# EUROPEAN PATENT APPLICATION

(11) **EP 4 812 012 A1**
(43) Date of publication of application: **23.09.2026**
(21) Application number: 25200851.1
(22) Date of filing: 08.09.2025
(51) Int. Cl.: H10W 90/20, H10B 43/40, H10P 54/30, H10W 90/00

(54) **METHOD OF MANUFACTURING SEMICONDUCTOR DEVICE**

(30) Priority: 21.03.2025 JP 2025046262
(71) Applicant: Kioxia Corporation, Tokyo 108-0023 (JP)
(72) Inventor: Itokawa, Hiroshi, Tokyo, 108-0023 (JP)
(74) Representative: Marks & Clerk LLP

(57) **Abstract**

A method of manufacturing a semiconductor device includes the steps of: stacking a first layer mainly composed of silicon and including germanium and oxygen on a first wafer; forming a first element and a first bonding electrode in the first wafer; forming a second element and a second bonding electrode in a second wafer; bonding the first wafer and the second wafer via the first bonding electrode and the second bonding electrode; and transmitting a laser light through a first substrate to irradiate the first layer with the laser light, and thereby induce cleavage in the first layer.

## Description

### BACKGROUND

### Field

The present embodiments relate to a method of manufacturing a semiconductor device.

### Description of the Related Art

There is known a method of manufacturing a semiconductor device, including bonding a wafer having a substrate and a certain layer to another wafer, and irradiating the certain layer with a laser light to detach the substrate.

### BRIEF DESCRIPTION OF THE DRAWINGS

FIG. 1 is a schematic circuit diagram showing a part of a configuration of a semiconductor device according to a first embodiment;
FIG. 2 is a schematic exploded perspective view showing a configuration example of same semiconductor device;
FIG. 3 is a schematic bottom view showing a configuration example of a chip C_{M} included in same semiconductor device;
FIG. 4 is a schematic cross-sectional view showing a part of a configuration of same semiconductor device;
FIG. 5 is a schematic cross-sectional view showing a part of a configuration of same semiconductor device;
FIG. 6 is a schematic bottom view showing a part of a configuration of the chip C_{M};
FIG. 7 is a schematic cross-sectional view showing a part of a configuration of the chip C_{M};
FIG. 8 is a schematic cross-sectional view for explaining a method of manufacturing the semiconductor device according to the first embodiment;
FIG. 9 is a schematic cross-sectional view for explaining same method of manufacturing;
FIG. 10 is a schematic cross-sectional view for explaining same method of manufacturing;
FIG. 11 is a schematic bottom view for explaining same method of manufacturing;
FIG. 12 is a schematic bottom view for explaining same method of manufacturing;
FIG. 13 is a schematic cross-sectional view for explaining same method of manufacturing;
FIG. 14 is a schematic cross-sectional view for explaining same method of manufacturing;
FIG. 15 is a schematic cross-sectional view for explaining same method of manufacturing;
FIG. 16 is a schematic cross-sectional view for explaining same method of manufacturing;
FIG. 17 is a schematic cross-sectional view for explaining same method of manufacturing;
FIG. 18 is a schematic cross-sectional view for explaining same method of manufacturing;
FIG. 19 is a schematic top view for explaining same method of manufacturing;
FIG. 20 is a schematic cross-sectional view for explaining same method of manufacturing;
FIG. 21 is a schematic cross-sectional view for explaining same method of manufacturing;
FIG. 22 is a schematic cross-sectional view for explaining same method of manufacturing;
FIG. 23 is a schematic cross-sectional view for explaining same method of manufacturing;
FIG. 24 is a schematic cross-sectional view for explaining same method of manufacturing;
FIG. 25 is a schematic cross-sectional view for explaining same method of manufacturing;
FIG. 26 is a schematic cross-sectional view for explaining same method of manufacturing;
FIG. 27 is a schematic top view for explaining same method of manufacturing;
FIG. 28 is a schematic top view for explaining same method of manufacturing;
FIG. 29 is a schematic cross-sectional view for explaining a method of manufacturing a semiconductor device according to a second embodiment;
FIG. 30 is a schematic cross-sectional view for explaining same method of manufacturing;
FIG. 31 is a schematic cross-sectional view for explaining same method of manufacturing;
FIG. 32 is a schematic cross-sectional view for explaining same method of manufacturing;
FIG. 33 is a schematic cross-sectional view for explaining same method of manufacturing;
FIG. 34 is a schematic cross-sectional view for explaining a method of manufacturing a semiconductor device according to a third embodiment;
FIG. 35 is a schematic cross-sectional view for explaining a method of manufacturing a semiconductor device according to a fourth embodiment;
FIG. 36 is a schematic cross-sectional view for explaining a method of manufacturing a semiconductor device according to the fourth embodiment;
FIG. 37 is a schematic circuit diagram showing a part of a configuration of a semiconductor device according to a fifth embodiment;
FIG. 38 is a schematic cross-sectional view showing a part of a configuration of the semiconductor device according to the fifth embodiment;
FIG. 39 is a schematic perspective view showing a part of a configuration of a semiconductor device according to a sixth embodiment; and
FIG. 40 is a schematic perspective view showing a part of a configuration of the semiconductor device according to the sixth embodiment.

### DETAILED DESCRIPTION

A method of manufacturing a semiconductor device according to one embodiment includes the steps of: stacking a first layer mainly composed of silicon and including germanium and oxygen on a first wafer having a first substrate; forming a first element and a first bonding electrode in the first wafer; forming a second element and a second bonding electrode in a second wafer; bonding the first wafer and the second wafer via the first bonding electrode and the second bonding electrode; and transmitting a laser light through the first substrate to irradiate the first layer with the laser light, and thereby induce cleavage in the first layer.

Next, methods of manufacturing a semiconductor device according to embodiments will be described in detail with reference to the drawings. Note that the following embodiments are merely examples, and are not shown with the intention of limiting the present invention. Moreover, the following drawings are schematic, and, for convenience of description, a part of a configuration, and so on, thereof will sometimes be omitted. Moreover, portions that are common to a plurality of embodiments will be assigned with the same symbols, and descriptions thereof sometimes omitted.

Moreover, when a "semiconductor device" is referred to in the present specification, it will sometimes mean a semiconductor memory device, and will sometimes mean a semiconductor device other than a semiconductor memory device. Moreover, when a "semiconductor memory device" is referred to in the present specification, it will sometimes mean a memory die, and will sometimes mean a memory system including a controller die, of the likes of a memory chip, a memory card, or an SSD (Solid State Drive). Furthermore, it will sometimes mean a configuration including a host computer, of the likes of a smartphone, a tablet terminal, or a personal computer.

Moreover, in the present specification, when a first configuration is said to be "electrically connected" to a second configuration, the first configuration may be connected to the second configuration directly, or the first configuration may be connected to the second configuration via the likes of a wiring, a semiconductor member, or a transistor. For example, in the case of three transistors having been connected in series, the first transistor is still "electrically connected" to the third transistor even when the second transistor is in an OFF state.

Moreover, in the present specification, when a first configuration is said to be "connected between" a second configuration and a third configuration, it will sometimes mean that the first configuration, the second configuration, and the third configuration are connected in series, and the second configuration is connected to the third configuration via the first configuration.

Moreover, in the present specification, when a circuit, or the like, is said to "make electrically conductive" two wirings, or the like, this will sometimes mean, for example, that this circuit, or the like, includes a transistor, or the like, that this transistor, or the like, is provided in a current path between the two wirings, and that this transistor, or the like, is in an ON state.

Moreover, in the present specification, a certain direction parallel to an upper surface of a substrate will be referred to as an X-direction, a direction parallel to the upper surface of the substrate and perpendicular to the X-direction will be referred to as a Y-direction, and a direction perpendicular to the upper surface of the substrate will be referred to as a Z-direction.

Moreover, in the present specification, a direction intersecting a certain plane will sometimes be referred to as a first direction. Moreover, a direction lying along the certain plane will sometimes be referred to as a second direction, and a direction intersecting the second direction along the certain plane will sometimes be referred to as a third direction. These first direction, second direction, and third direction may correspond to any of the Z-direction, the X-direction, and the Y-direction, but need not do so.

Moreover, in the present specification, expressions such as "above" or "below" will be defined with reference to the substrate. For example, an orientation of moving away from the substrate along the above-described Z-direction will be referred to as above, and an orientation of coming closer to the substrate along the Z-direction will be referred to as below. Moreover, when a lower surface or a lower end is referred to for a certain configuration, this will be assumed to mean a surface or end portion on a substrate side of this configuration, and when an upper surface or an upper end is referred to for a certain configuration, this will be assumed to mean a surface or end portion on an opposite side to the substrate of this configuration. Moreover, a surface intersecting the X-direction or the Y-direction will be referred to as a side surface, and so on.

Moreover, in the present specification, when the likes of a "width", a "length", or a "thickness" in a certain direction is referred to for a configuration, a member, and so on, this will sometimes mean a width, a length, or a thickness, and so on, in a cross section observed by the likes of SEM (Scanning Electron Microscopy) or TEM (Transmission Electron Microscopy), and so on.

Moreover, in the present specification, when a "wiring" is referred to, this will sometimes include the likes of a wiring, a contact electrode, a connecting portion for connecting a wiring and a contact electrode, or a bonding electrode.

### [First Embodiment]

### [Circuit Configuration of Memory Die MD]

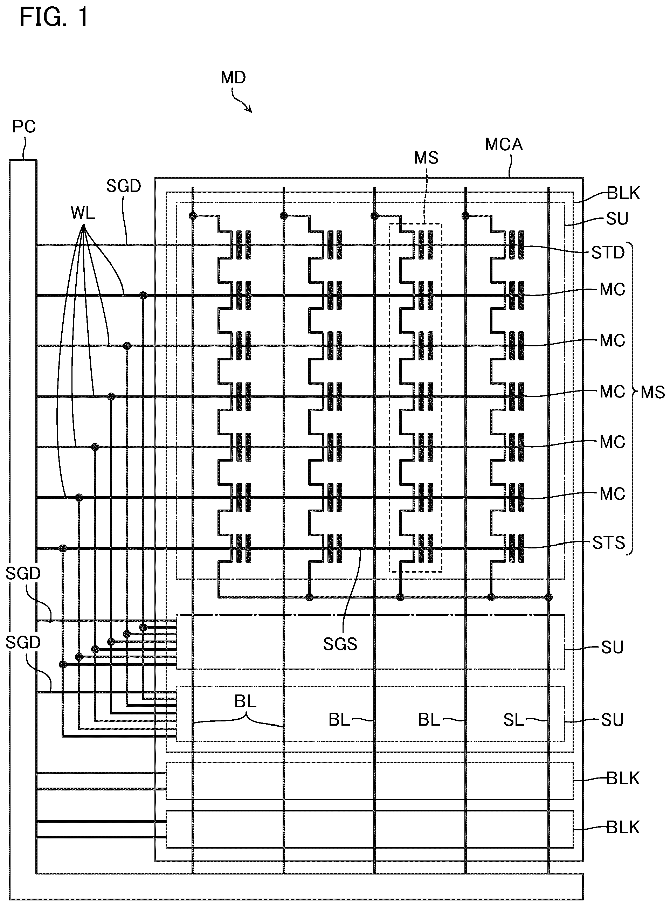

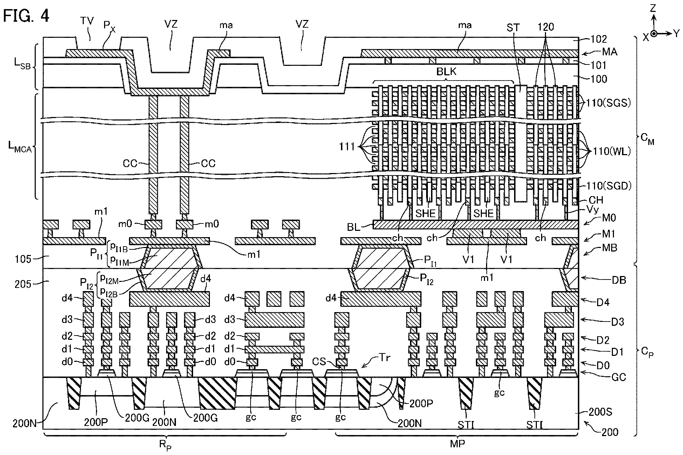

FIG. 1 is a schematic circuit diagram showing a part of a configuration of a semiconductor device according to a first embodiment. In the first embodiment, a memory die MD is exemplified as one example of the semiconductor device. As shown in FIG. 1, the memory die MD comprises a memory cell array MCA and a peripheral circuit PC. The memory cell array MCA is one example of a first element. Moreover, the peripheral circuit PC includes a plurality of transistors Tr (refer to FIG. 4). These plurality of transistors Tr are one example of a second element.

### [Circuit Configuration of Memory Cell Array MCA]

As shown in FIG. 1, the memory cell array MCA comprises a plurality of memory blocks BLK. These plurality of memory blocks BLK each comprise a plurality of string units SU. These plurality of string units SU each comprise a plurality of memory strings MS. One ends of these plurality of memory strings MS are each connected to the peripheral circuit PC via bit lines BL. Moreover, the other ends of these plurality of memory strings MS are each connected to the peripheral circuit PC via a common source line SL.

The memory string MS comprises a drain side select transistor STD, a plurality of memory cells MC (memory transistors), and a source side select transistor STS. The drain side select transistor STD, the plurality of memory cells MC, and the source side select transistor STS are connected in series between the bit line BL and the source line SL. Hereafter, the drain side select transistor STD and the source side select transistor STS will sometimes simply be referred to as select transistors (STD, STS).

The memory cell MC is a field effect type transistor. The memory cell MC comprises a semiconductor layer, a gate insulating film, and a gate electrode. The semiconductor layer functions as a channel region. The gate insulating film includes an electric charge accumulating film. A threshold voltage of the memory cell MC changes according to an amount of electric charge in the electric charge accumulating film. The memory cell MC stores 1 bit or a plurality of bits of data. Note that the respective gate electrodes of the plurality of memory cells MC corresponding to one memory string MS are connected with word lines WL. These respective word lines WL are commonly connected to all of the memory strings MS in one memory block BLK.

The select transistors (STD, STS) are field effect type transistors. The select transistors (STD, STS) each comprise a semiconductor layer, a gate insulating film, and a gate electrode. The semiconductor layer functions as a channel region. The gate insulating film may include an electric charge accumulating film. The gate electrode of the drain side select transistor STD is connected with a drain side select gate line SGD, and the gate electrode of the source side select transistor STS is connected with a source side select gate line SGS. One drain side select gate line SGD is commonly connected to all of the memory strings MS in one string unit SU. One source side select gate line SGS is commonly connected to all of the memory strings MS in one memory block BLK.

### [Structure of Memory Die MD]

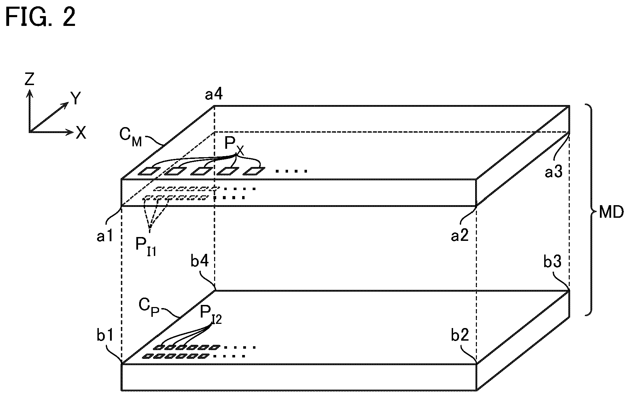

FIG. 2 is a schematic exploded perspective view showing a configuration example of the semiconductor device according to the first embodiment. As shown in FIG. 2, the memory die MD comprises: a chip C_{M} on a memory cell array MCA side; and a chip C_{P} on a peripheral circuit PC side.

An upper surface of the chip C_{M} is provided with a plurality of external pad electrodes P_{X} connectable to unillustrated bonding wires. Moreover, a lower surface of the chip C_{M} is provided with a plurality of bonding electrodes (first bonding electrodes) P_{I1}. Moreover, an upper surface of the chip C_{P} is provided with a plurality of bonding electrodes P_{I2}. Hereafter, a surface provided with the plurality of bonding electrodes P_{I1}, of the chip C_{M} will be referred to as a front surface of the chip C_{M}, and a surface provided with the plurality of external pad electrodes P_{X}, of the chip C_{M} will be referred to as a back surface of the chip C_{M}. Moreover, a surface provided with the plurality of bonding electrodes P_{I2}, of the chip C_{P} will be referred to as a front surface of the chip C_{P}, and a surface on an opposite side to the front surface, of the chip C_{P} will be referred to as a back surface of the chip C_{P}. In the example illustrated, the front surface of the chip C_{P} is provided above the back surface of the chip C_{P}, and the back surface of the chip C_{M} is provided above the front surface of the chip C_{M}.

The chip C_{M} and the chip C_{P} are disposed so that the front surface of the chip C_{M} and the front surface of the chip C_{P} face each other. The respective plurality of bonding electrodes P_{I1} are provided correspondingly to the plurality of bonding electrodes (second bonding electrodes) P_{I2}, and are disposed at positions enabling them to be bonded to the plurality of bonding electrodes P_{I2}. The bonding electrodes P_{I1} and the bonding electrodes P_{I2} function as bonding electrodes for bonding and making electrically conductive the chip C_{M} and chip C_{P}.

Note that in the example of FIG. 2, corners a1, a2, a3, a4 of the chip C_{M} respectively correspond to corners b1, b2, b3, b4 of the chip C_{P}.

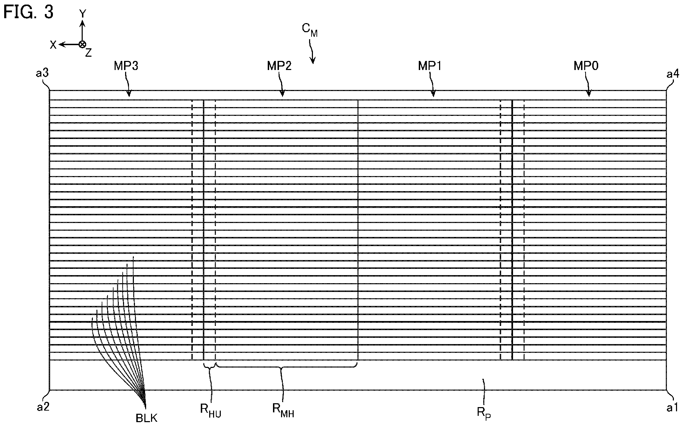

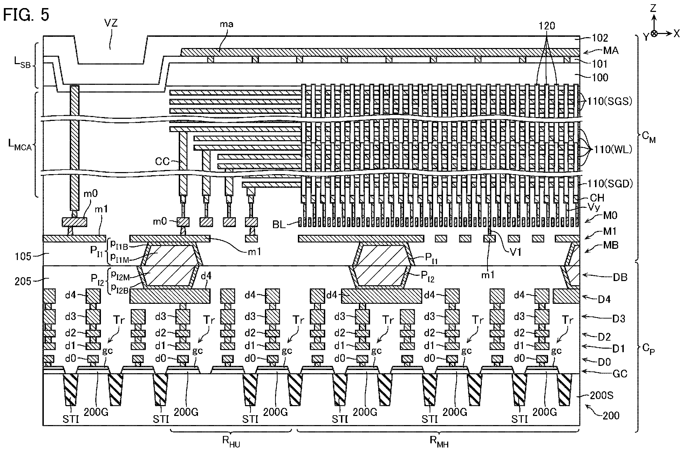

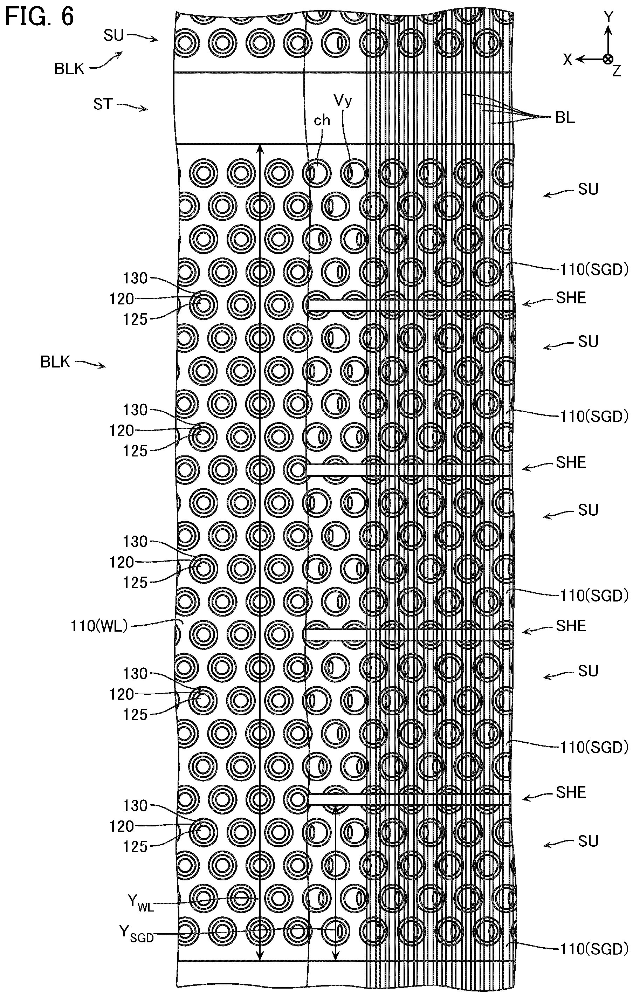

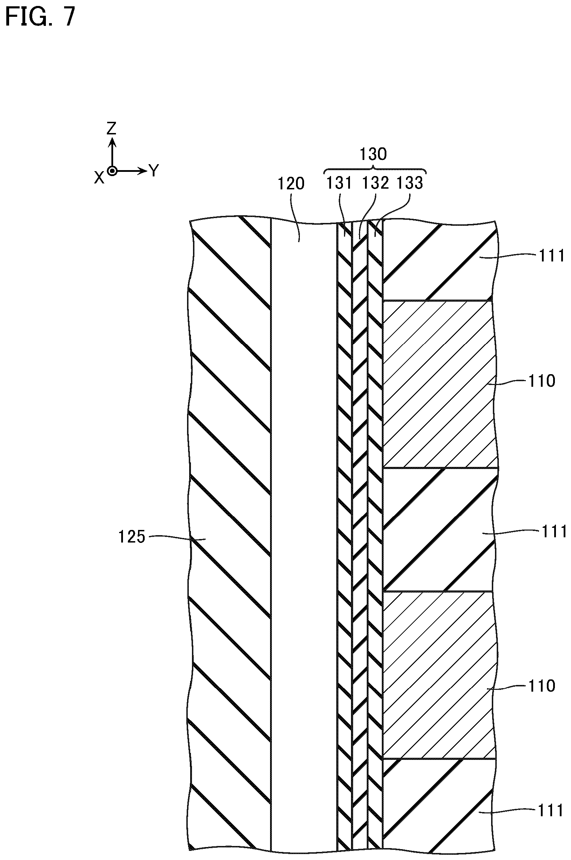

FIG. 3 is a schematic bottom view showing a configuration example of the chip C_{M}. In FIG. 3, a part of a configuration such as the bonding electrodes P_{I1} is omitted. FIGS. 4 and 5 are schematic cross-sectional views showing a part of a configuration of the semiconductor device according to the first embodiment. FIG. 6 is a schematic bottom view showing a part of a configuration of the chip C_{M}. In FIG. 6, a region on the left side shows an XY cross section at a position of the word lines WL, and a region on the right side shows an XY cross section at a position of the drain side select gate line SGD. Note that in order to indicate connecting portions of semiconductor columns 120 and the bit lines BL, the region on the right side of FIG. 6 also shows contact electrodes ch, Vy and the bit lines BL. The contact electrodes ch, Vy and the bit lines BL are also provided in the region on the left side of FIG. 6. FIG. 7 is a schematic cross-sectional view showing a part of a configuration of the chip C_{M}. Although FIG. 7 shows a YZ cross section, a similar structure to in FIG. 7 will be observed, even in the case where a cross section other than a YZ cross section (for example, an XZ cross section) along a central axis of the semiconductor column 120 has been observed.

### [Structure of Chip C_{M}]

In the example of FIG. 3, the chip C_{M} comprises four memory planes MP0-MP3 arranged in the X-direction. Note that sometimes, the four memory planes MP0-MP3 will each simply be referred to as a memory plane MP. Moreover, these four memory planes MP0-MP3 each comprise a plurality of the memory blocks BLK arranged in the Y-direction. Moreover, in the example of FIG. 3, these four memory planes MP0-MP3 each comprise: a memory hole region R_{MH} (a memory region); and a hook-up region R_{HU} provided on one side in the X-direction with respect to the memory hole region R_{MH}. Moreover, the chip C_{M} comprises a peripheral region R_{P} provided further to a side at one end in the Y-direction of the chip C_{M} than the four memory planes MP0-MP3.

Note that in the example illustrated, the hook-up region R_{HU} is provided on one side in the X-direction with respect to the memory hole region R_{MH}. However, such a configuration is merely an exemplification, and a specific configuration can be appropriately adjusted. For example, the hook-up region R_{HU} may be provided on both sides in the X-direction with respect to the memory hole region R_{MH}. Moreover, the hook-up region R_{HU} may be provided at a center position or near center position in the X-direction of the memory plane MP.

As shown in FIG. 4, for example, the chip C_{M} comprises: a substrate layer L_{SB}; a memory cell array layer L_{MCA} provided below the substrate layer L_{SB}; a contact electrode layer CH provided below the memory cell array layer L_{MCA}; a plurality of wiring layers M0, M1 provided below the contact electrode layer CH; and a chip bonding electrode layer MB provided below the wiring layers M0, M1.

### [Structure of Substrate Layer L_{SB} of Chip C_{M}]

As shown in FIG. 4, for example, the substrate layer L_{SB} comprises: a conductive layer 100 provided on an upper surface of the memory cell array layer L_{MCA}; an insulating layer 101 provided on an upper surface of the conductive layer 100; a back surface wiring layer MA provided on an upper surface of the insulating layer 101; and an insulating layer 102 provided on an upper surface of the back surface wiring layer MA.

The conductive layer 100 may include a semiconductor layer of the likes of silicon (Si) implanted with an N-type impurity such as phosphorus (P) or a P-type impurity such as boron (B), may include a metal of the likes of tungsten (W), or may include a silicide of the likes of tungsten silicide (WSi), for example.

The conductive layer 100 functions as a part of the source line SL (FIG. 1). Four conductive layers 100 are provided correspondingly to the four memory planes MP0-MP3 (FIG. 3). End portions in the X-direction and Y-direction of the memory plane MP are provided with a region VZ that does not include the conductive layer 100.

The insulating layer 101 includes the likes of silicon oxide (SiO₂), for example.

The back surface wiring layer MA includes a plurality of wirings ma. These plurality of wirings ma may include the likes of aluminum (Al), for example.

A part of the plurality of wirings ma functions as part of the source line SL (FIG. 1). Four of these wirings ma are provided correspondingly to the four memory planes MP0-MP3 (FIG. 3). This wiring ma is electrically connected to a respective conductive layer 100.

Moreover, a part of the plurality of wirings ma functions as the external pad electrode P_{X}. This wiring ma is provided in the peripheral region R_{P}. This wiring ma is connected to a contact electrode CC within the memory cell array layer L_{MCA} in the region VZ not including the conductive layer 100. Moreover, a part of the wiring ma is exposed to outside of the memory die MD via an opening TV provided in the insulating layer 102.

The insulating layer 102 is a passivation layer consisting of an insulating material such as a polyimide, for example.

### [Structure in Memory Hole Region R_{MH} of Memory Cell Array Layer L_{MCA} of Chip C_{M}]

As described with reference to FIG. 3, the memory cell array layer L_{MCA} is provided with a plurality of the memory blocks BLK arranged in the Y-direction. As shown in FIG. 4, an inter-block insulating layer ST of the likes of silicon oxide (SiO₂) is provided between two memory blocks BLK adjacent in the Y-direction.

A shown in FIG. 4, for example, the memory block BLK comprises: a plurality of conductive layers 110 arranged in the Z-direction (stacked in the Z-direction); and a plurality of the semiconductor columns 120 extending in the Z-direction. Moreover, as shown in FIG. 7, a gate insulating film 130 is provided between each of the plurality of conductive layers 110 and the plurality of semiconductor columns 120.

The conductive layer 110 comprises a substantially platelike shape extending in the X-direction. The conductive layer 110 may be mainly composed of tungsten (W) or molybdenum (Mo), for example. Moreover, the conductive layer 110 may be mainly composed of the likes of polycrystalline silicon including an impurity such as phosphorus (P) or boron (B), for example. Moreover, the conductive layer 110 may be mainly composed of titanium nitride (TiN). An inter-layer insulating layer 111 of the likes of silicon oxide (SiO₂) is provided between the plurality of conductive layers 110 arranged in the Z-direction.

One or a plurality of conductive layers 110 located in the uppermost layer, of the plurality of conductive layers 110 function as the gate electrodes of the source side select transistors STS (FIG. 1) and as the source side select gate line SGS (refer to FIG. 4). These plurality of conductive layers 110 are electrically independent every memory block BLK.

Moreover, a plurality of conductive layers 110 located below these uppermost conductive layers 110 function as the gate electrodes of the memory cells MC (FIG. 1) and as the word lines WL. These plurality of conductive layers 110 are each electrically independent every memory block BLK.

Moreover, one or a plurality of conductive layers 110 located below the conductive layers 110 function as the gate electrodes of the drain side select transistors STD (FIG. 1) and as the drain side select gate line SGD. As shown in FIG. 6, for example, width Y_{SGD} in the Y-direction of these plurality of conductive layers 110 is less than width Y_{WL} in the Y-direction of the conductive layers 110 functioning as the word lines WL. Moreover, an inter-string unit insulating layer SHE of the likes of silicon oxide (SiO₂) is provided between two conductive layers 110 adjacent in the Y-direction.

As shown in FIG. 6, for example, the semiconductor columns 120 are arranged in a certain pattern in the X-direction and the Y-direction. The respective semiconductor columns 120 function as channel regions of the plurality of memory cells MC and the select transistors (STD, STS) included in one memory string MS (FIG. 1). The semiconductor column 120 is an oxide mainly composed of at least one of titanium and indium. Specifically, the semiconductor column 120 can employ at least one of titanium oxide (TiO₂), indium oxide (In₂O₃), indium gallium oxide (InGaO₃), and indium gallium zinc oxide (InGaZnO, IGZO). The semiconductor column 120 has a substantially cylindrical shape, and has its central portion provided with an insulating layer 125 of the likes of silicon oxide. An outer peripheral surface of the semiconductor column 120 is surrounded by each of a plurality of the conductive layers 110, and faces these plurality of conductive layers 110.

Moreover, an upper end of the semiconductor column 120 is connected to the above-described conductive layer 100 (refer to FIG. 4).

Moreover, a lower end of the semiconductor column 120 is connected to the bit line BL via the contact electrode ch and the contact electrode Vy.

As shown in FIG. 6, for example, the gate insulating film 130 has a substantially cylindrical shape covering the outer peripheral surface of the semiconductor column 120. The gate insulating film 130 includes a ferroelectric film.

The gate insulating film 130 comprises, for example: a ferroelectric film 132 of substantially cylindrical shape, extending in the Z-direction over a range in the Z-direction corresponding to the plurality of conductive layers 110, along the outer peripheral surface of the semiconductor column 120; an insulating film 131 of substantially cylindrical shape, extending in the Z-direction over a range in the Z-direction corresponding to the plurality of conductive layers 110, along an inner peripheral surface of the ferroelectric film 132; and an insulating film 133 of substantially cylindrical shape, extending in the Z-direction over a range in the Z-direction corresponding to the plurality of conductive layers 110, along an outer peripheral surface of the ferroelectric film 132.

The ferroelectric film 132 is mainly composed of at least one of silicon (Si), aluminum (Al), hafnium (Hf), and zirconium (Zr). The ferroelectric film 132 may be an insulating film including orthorhombic hafnium oxide, for example. The hafnium oxide included in the ferroelectric film 132 may be mainly orthorhombic. More specifically, the hafnium oxide included in the ferroelectric film 132 may be mainly type III orthorhombic (orthorhombic III, space group Pbc21, space group number 29). A proportion accounted for by orthorhombic crystals may be greatest among crystals of hafnium oxide included in the ferroelectric film 132. Note that orthorhombic is also referred to as orthorhombic. Crystalline structure in the ferroelectric film 132 is observable by a method such as ACOM-TEM (Automated Crystal Orientation Mapping Transmission Electron Microscopy), for example.

Moreover, the ferroelectric film 132 can include at least one added element selected from the group consisting of silicon (Si), zirconium (Zr), aluminum (Al), yttrium (Y), strontium (Sr), lanthanum (La), samarium (Sm), gadolinium (Gd), terbium (Tb), dysprosium (Dy), holmium (Ho), erbium (Er), ytterbium (Yb), lutetium (Lu), and barium (Ba). Hereafter, such an added element will sometimes be referred to as a "first added element". Note that presence and concentration of the added element can be confirmed by a method such as EDX (Energy Dispersive X-ray Spectroscopy), for example.

From a viewpoint of manifesting ferroelectric characteristics in the hafnium oxide, concentration of the above-described first added element is preferably between 0.1 atomic % and 80 atomic % inclusive. Appropriate range of concentration of the above-described first added element for manifesting ferroelectric characteristics in the hafnium oxide differs according to a kind of the first added element. For example, if the first added element is silicon (Si), then the appropriate range of concentration of the first added element for manifesting ferroelectric characteristics will be between 3 atomic % and 7 atomic % inclusive. For example, when the first added element is barium (Ba), then the appropriate range of concentration of the first added element for manifesting ferroelectric characteristics will be between 0.1 atomic % and 3 atomic % inclusive. For example, when the first added element is zirconium (Zr), then the appropriate range of concentration of the first added element for manifesting ferroelectric characteristics will be between 10 atomic % and 80 atomic % inclusive.

### [Structure in Hook-up Region R_{HU} of Memory Cell Array Layer L_{MCA} of Chip C_{M}]

As shown in FIG. 5, the hook-up region R_{HU} is provided with a plurality of terrace portions of the conductive layers 110(WL, SGD, SGS). The terrace portion is a portion of a lower surface of a conductive layer 110 that, viewed from below, does not overlap another conductive layer 110. Below the plurality of conductive layers 110 is filled in by an insulating layer 105 mainly composed of silicon oxide. In addition, the hook-up region R_{HU} is provided with a plurality of the contact electrodes CC. These plurality of contact electrodes CC each extend in the Z-direction penetrating the insulating layer 105, and are connected at their upper ends to the terrace portions of the conductive layers 110(WL, SGD, SGS).

### [Structure in Peripheral Region R_{P} of Memory Cell Array Layer L_{MCA} of Chip C_{M}]

As shown in FIG. 4, for example, the peripheral region R_{P} is filled in by the insulating layer 105. Moreover, a plurality of the contact electrodes CC are provided in the peripheral region R_{P}, correspondingly to the external pad electrodes P_{X}. These plurality of contact electrodes CC each extend in the Z-direction penetrating the insulating layer 105, and are connected at their upper ends to the external pad electrode P_{X}.

### [Structure of Contact Electrode Layer CH of Chip C_{M}]

The contact electrode layer CH is filled in by the insulating layer 105. Moreover, the contact electrode layer CH is provided with a plurality of the contact electrodes ch. These plurality of contact electrodes ch each extend in the Z-direction penetrating the insulating layer 105, and are electrically connected to either or both of configurations in the memory cell array layer L_{MCA} and configurations in the chip C_{P}, for example.

The contact electrode layer CH includes the plurality of contact electrodes ch as a plurality of wirings. These plurality of contact electrodes ch may include for example a stacked film having stacked therein a barrier conductive film of the likes of titanium nitride (TiN) and a metal film of the likes of tungsten (W), and so on. The contact electrodes ch, which are provided correspondingly to the plurality of semiconductor columns 120, are connected to the lower ends of the plurality of semiconductor columns 120.

### [Structure of Wiring Layers M0, M1 of Chip C_{M}]

The wiring layers M0, M1 comprise: pluralities of wirings m0, m1; and the insulating layer 105 filled into peripheries of these pluralities of wirings m0, m1. The pluralities of wirings m0, m1 are electrically connected to either or both of the configurations in the memory cell array layer L_{MCA} and the configurations in the chip C_{P}, for example.

The plurality of wirings m0 may include for example the likes of a stacked film having stacked therein: a barrier conductive film of the likes of titanium nitride (TiN), tantalum nitride (TaN), or a stacked film of tantalum nitride (TaN) and tantalum (Ta); and a metal film of the likes of copper (Cu). Note that a part of the plurality of wirings m0 functions as the bit lines BL. As shown in FIG. 6, for example, the bit lines BL are arranged in the X-direction and extend in the Y-direction.

The plurality of wirings m1 may include for example a stacked film having stacked therein a barrier conductive film of the likes of titanium nitride (TiN) and a metal film of the likes of tungsten (W), and so on. Moreover, as shown in FIGS. 4 and 5, for example, these plurality of wirings m1 are electrically connected to the wiring m0 via a contact electrode V1.

### [Structure of Chip Bonding Electrode Layer MB]

The chip bonding electrode layer MB comprises: a plurality of the bonding electrodes P_{I1}; and the insulating layer 105 filled into peripheries of these plurality of bonding electrodes P_{I1}. The plurality of bonding electrodes P_{I1} are electrically connected to either or both of the configurations in the memory cell array layer L_{MCA} and the configurations in the chip C_{P}, for example.

The plurality of bonding electrodes P_{I1} may include for example the likes of a stacked film having stacked therein: a barrier conductive film p_{I1B} of the likes of titanium nitride (TiN), tantalum nitride (TaN), or a stacked film of tantalum nitride (TaN) and tantalum (Ta); and a metal film p_{I1M} of the likes of copper (Cu).

### [Structure of Chip C_{P}]

As shown in FIG. 4, for example, the chip C_{P} comprises: a semiconductor substrate (second substrate) 200; an electrode layer GC provided above the semiconductor substrate 200; wiring layers D0, D1, D2, D3, D4 provided above the electrode layer GC; and a chip bonding electrode layer DB provided above the wiring layers D0, D1, D2, D3, D4.

### [Structure of Semiconductor Substrate 200 of Chip C_{P}]

The semiconductor substrate 200 includes P-type silicon (Si) that includes a P-type impurity such as boron (B), for example. A surface of the semiconductor substrate 200 is provided with, for example: an N-type well region 200N including an N-type impurity such as phosphorus (P); a P-type well region 200P including a P-type impurity such as boron (B); a semiconductor substrate region 200S where the N-type well region 200N and the P-type well region 200P are not provided; and an insulating region STI. A part of the P-type well regions 200P is provided in the semiconductor substrate region 200S, and a part of the P-type well regions 200P is provided in the N-type well region 200N. The N-type well region 200N, the P-type well regions 200P provided in the N-type well region 200N and the semiconductor substrate region 200S, and the semiconductor substrate region 200S each function as parts of a plurality of transistors Tr and a plurality of capacitors, and so on, configuring the peripheral circuit PC. The insulating region STI includes the likes of silicon oxide (SiO₂), for example, and extends in the Z-direction.

### [Structure of Electrode Layer GC of Chip C_{P}]

The electrode layer GC is provided on an upper surface of the semiconductor substrate 200 via an insulating layer 200G. The electrode layer GC includes: a plurality of electrodes gc facing the surface of the semiconductor substrate 200; and an insulating layer 205 filled into peripheries of these plurality of electrodes gc, and mainly composed of silicon oxide. Each of the regions of the semiconductor substrate 200 and each of the plurality of electrodes gc included in the electrode layer GC are connected to contact electrodes CS.

The respective plurality of electrodes gc included in the electrode layer GC function as gate electrodes of the plurality of transistors Tr, and so on, configuring the peripheral circuit PC.

The contact electrode CS extends in the Z-direction, and is connected at its lower end to an upper surface of the semiconductor substrate 200 or the electrode gc. A connecting portion of the contact electrode CS and the semiconductor substrate 200 is provided with an impurity region including an N-type impurity or P-type impurity. The contact electrode CS may include for example a stacked film having stacked therein a barrier conductive film of the likes of titanium nitride (TiN) and a metal film of the likes of tungsten (W), and so on.

### [Structure of Wiring Layers D0, D1, D2, D3, D4 of Chip C_{P}]

As shown in FIG. 4, for example, the wiring layers D0, D1, D2, D3, D4 comprise: pluralities of wirings d0, d1, d2, d3, d4; and the insulating layer 205 filled into peripheries of these pluralities of wirings d0, d1, d2, d3, d4. The pluralities of wirings d0, d1, d2, d3, d4 are electrically connected to either or both of the configurations in the memory cell array layer L_{MCA} and the configurations in the chip C_{P}, for example.

The pluralities of wirings d0, d1, d2 may include for example a stacked film having stacked therein a barrier conductive film of the likes of titanium nitride (TiN) and a metal film of the likes of tungsten (W), and so on.

The pluralities of wirings d3, d4 may include for example the likes of a stacked film having stacked therein: a barrier conductive film of the likes of titanium nitride (TiN), tantalum nitride (TaN), or a stacked film of tantalum nitride (TaN) and tantalum (Ta); and a metal film of the likes of copper (Cu).

### [Structure of Chip Bonding Electrode Layer DB]

The chip bonding electrode layer DB comprises: the plurality of the bonding electrodes P_{I2}; and the insulating layer 205 filled into peripheries of these plurality of bonding electrodes P_{I2}. The plurality of bonding electrodes P_{I2} are electrically connected to either or both of the configurations in the memory cell array layer L_{MCA} and the configurations in the chip C_{P}, for example.

The plurality of bonding electrodes P_{I2} may include for example the likes of a stacked film having stacked therein: a barrier conductive film p_{I2B} of the likes of titanium nitride (TiN), tantalum nitride (TaN), or a stacked film of tantalum nitride (TaN) and tantalum (Ta); and a metal film p_{I2M} of the likes of copper (Cu).

Note that when the metal films p_{I1M}, p_{I2M} of the likes of copper (Cu) are employed in the bonding electrode P_{I1} and the bonding electrode P_{I2}, the metal film p_{I1M} and the metal film p_{I2M} become one metal film, so that identification of their boundary with each other becomes difficult. However, due to distortion of shape where the bonding electrode P_{I1} and the bonding electrode P_{I2} have been bonded resulting from positional shift of bonding, and due to positional shift (generation of discontinuous places in side surfaces) of the barrier conductive films p_{I1B}, p_{I2B}, bonding structure can be identified. Moreover, when the bonding electrode P_{I1} and the bonding electrode P_{I2} are formed by a damascene method, their respective side surfaces will have a tapered shape. Therefore, a shape of a cross section along the Z-direction in a portion where the bonding electrode P_{I1} and the bonding electrode P_{I2} have been bonded will be non-rectangular due to side walls being nonlinearly shaped. Moreover, when the bonding electrode P_{I1} and the bonding electrode P_{I2} are bonded, there will be a structure where each of a bottom surface, a side surface, and an upper surface of the Cu forming them will be covered by a barrier metal. In contrast, in a general wiring layer employing Cu, the upper surface of the Cu is provided with an insulating layer (of the likes of SiN or SiCN) functioning to prevent oxidation of the Cu, and is not provided with a barrier metal. Therefore, distinction from a general wiring layer is possible, even when positional shift of bonding has not occurred.

### [Method of Manufacturing]

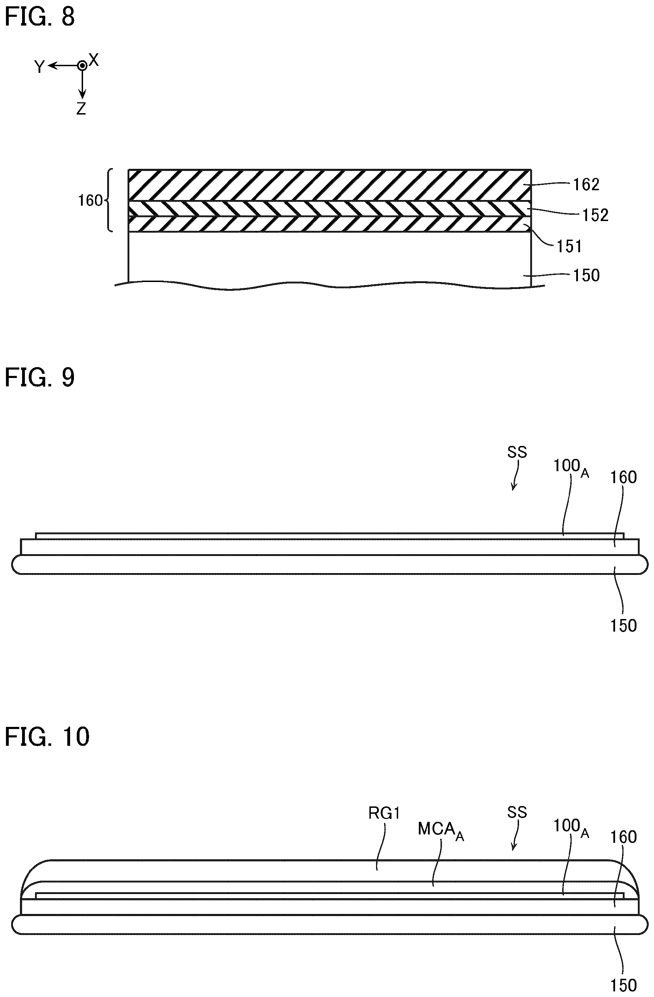

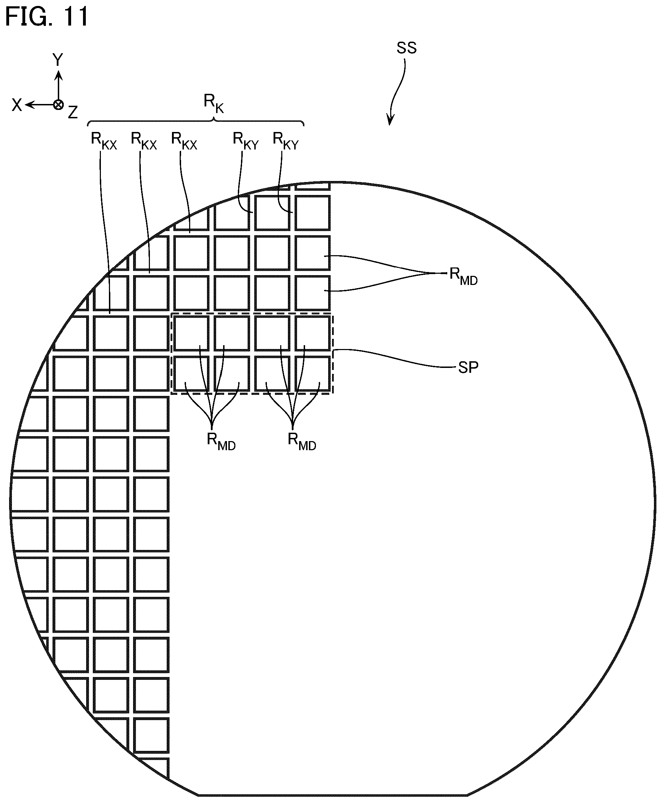

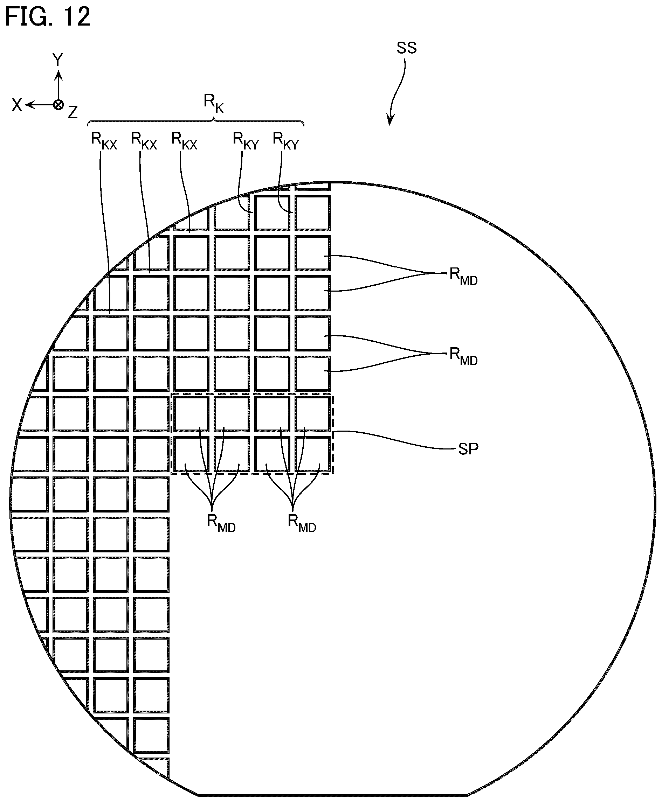

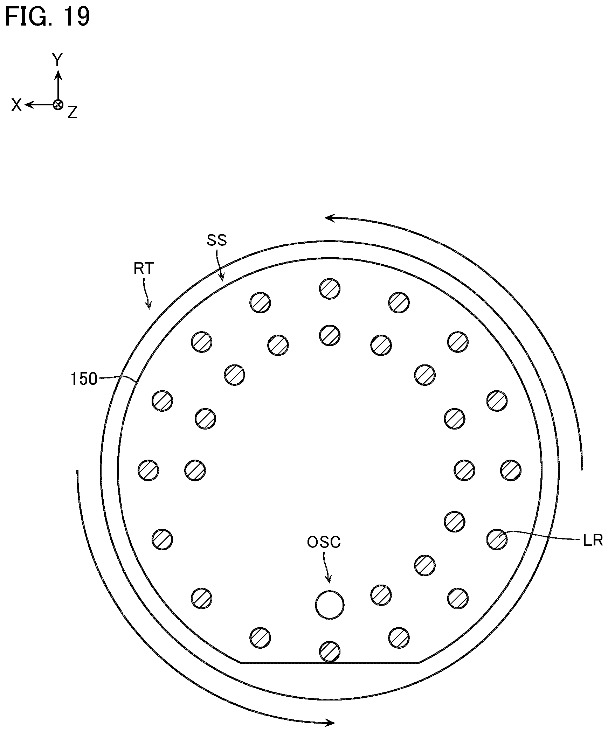

Next, a method of manufacturing a semiconductor device according to the first embodiment will be described with reference to FIGS. 8 to 28. FIGS. 8 to 10, 13 to 18, and 20 to 26 are schematic cross-sectional views for explaining same method of manufacturing. FIGS. 11 and 12 are schematic bottom views for explaining same method of manufacturing. FIGS. 19, 27, and 28 are schematic top views for explaining same method of manufacturing.

In same method of manufacturing, as shown in FIG. 8, first, a first substrate 150 is prepared. The first substrate 150, which is assumed to be a silicon substrate or silicon carbide substrate, is a substrate having light transmittance. In the present embodiment, "having light transmittance" refers to having a property that at least later-mentioned laser light will be transmitted. For example, a transmittance rate of laser light may be set to 40% or more for the first substrate 150. Moreover, a substrate with a resistance rate of 1 to 100 Ω·cm (ohm centimeters), for example, may be used as the first substrate 150.

Next, both surfaces of the first substrate 150 are cleaned, and then an insulating layer 151 mainly composed of silicon nitride, or the like, is formed on the first substrate 150. The insulating layer 151 is formed using the likes of CVD (Chemical Vapor Deposition), for example. A layer thickness of the insulating layer 151, which may be 300 nm or less, may be 200 nm or less, and is preferably between 50 nm and 100 nm inclusive, may be set to 70 nm, for example.

Moreover, an insulating layer 152 of the likes of a silicon oxide layer is formed on the insulating layer 151, for example. A layer thickness of the insulating layer 152 may be 300 nm or less, may be 200 nm or less, and may be preferably set to between 50 nm and 100 nm inclusive. The insulating layers 151, 152 are one example of a protective layer stacked on the first substrate. Note that as other embodiments, either one of the insulating layers 151, 152 may be formed, or neither of the insulating layers 151, 152 need be formed.

Next, as shown in FIG. 8, a first layer 162 mainly composed of silicon (Si) and including germanium (Ge) and oxygen (O) is stacked on the insulating layer 152.

The first layer 162 includes germanium dioxide (GeO₂). Moreover, the first layer 162 may include a germanium (Ge) simple substance, a silicon (Si) simple substance, or silicon oxide (SiO₂). Furthermore, the first layer 162 is polycrystalline.

A content rate of each component contained in the first layer 162 is not particularly limited, but from a viewpoint of etching resistance and thermal stability, for example, a content rate of germanium (Ge) in the first layer 162 is preferably greater than or equal to 10 atomic % but less than 50 atomic %, is more preferably between 20 atomic % and 40 atomic % inclusive, and is even more preferably between 25 atomic % and 35 atomic % inclusive. Moreover, for example, a content rate of silicon (Si) in the first layer 162, which may be greater than a total of content rates of germanium (Ge) and oxygen (O) in the first layer 162, may be set to greater than or equal to 50 atomic %, may be set to greater than or equal to 60 atomic %, or may be set to greater than or equal to 70 atomic %. Moreover, for example, a content rate of oxygen (O) in the first layer 162 may be set to less than 50 atomic %, may be set to less than or equal to 40 atomic %, or may be set to less than or equal to 30 atomic %.

A layer thickness of the first layer 162 is not particularly limited, but may be set to 500 nm or less, may be set to 300 nm or less, or may be set to 200 nm or less.

A film-forming method of the first layer 162 is not particularly limited, but the first layer 162 can be formed by, for example, forming an unoxidized layer including silicon and germanium by CVD, PVD (Physical Vapor Deposition) of the likes of sputtering, and so on, then oxidizing the unoxidized layer by, for example, oxidation process such as thermal oxidation, atmospheric exposure, and so on, and repeating these formation of the unoxidized layer and oxidation of the unoxidized layer as required. For example, the content rate of each component contained in the first layer 162 can be appropriately changed by adjusting concentration of raw materials used in the PVD, and so on, or adjusting a time that the oxidation process is performed, and so on.

Hereafter, a configuration comprising the first substrate 150, the insulating layers 151, 152, and the first layer 162 will be referred to as a first wafer SS. Moreover, the insulating layers 151, 152 and the first layer 162 will be referred to as a stacked portion 160.

Next, as shown in FIG. 9, a conductive layer 100_{A} is formed on the stacked portion 160 by CVD, or the like. The conductive layer 100_{A} will later become the conductive layer 100 (source line SL) in the memory die MD. Then, as shown in FIG. 10, a plurality of silicon nitride layers and a plurality of silicon oxide layers are alternately stacked on the conductive layer 100_{A} by the likes of CVD to form a stacked body MCA_{A}. Then, the stacked body MCA_{A}, is coated with a resist RG1.

Next, as shown in FIGS. 11 and 12, for example, patterning is performed by a means such as photolithography. During patterning, a stepper, or the like, is employed to sequentially perform transfers to the resist of a pattern (hereafter, referred to as a "shot pattern SP") corresponding to a plurality of die regions R_{MD}, in an entire region in the first wafer SS. In the example illustrated, the shot pattern SP includes a pattern corresponding to a four-by-two arrangement of die regions R_{MD} in the X-direction and Y-direction, that is, a total of eight die regions R_{MD}. Note that FIG. 11 exemplifies a state after execution of the 10^{th} transfer. FIG. 12 exemplifies a state after execution of the 11^{th} transfer.

Note that FIGS. 11 and 12 exemplify a kerf region R_{K} provided between the plurality of die regions R_{MD}. The plurality of die regions R_{MD} are each a region that is to become a part of the memory die MD, due to the die regions R_{MD} being individualized by later-mentioned dicing. The kerf region R_{K} includes a dicing line. The kerf region R_{K} comprises: a plurality of kerf regions R_{KY} extending in the Y-direction along a part of the dicing lines and arranged in the X-direction; and a plurality of kerf regions R_{KX} extending in the X-direction along a part of the dicing lines and arranged in the Y-direction.

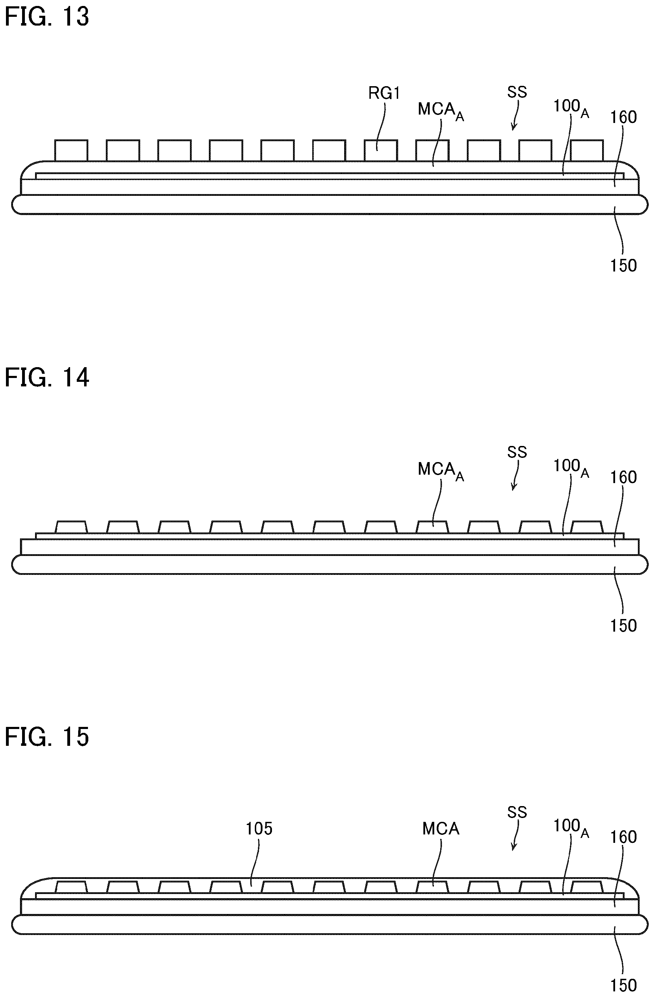

Next, as shown in FIG. 13, a part of the resist RG1 is removed, and a part of the stacked body MCA_{A}, that had been covered by the resist RG1 is exposed. This step is performed by a means such as wet etching, for example.

Then, as shown in FIG. 14, the stacked body MCA_{A}, is divided every memory cell array MCA (every memory plane MP). In this step, removal of the silicon oxide layer in the stacked body MCA_{A}, by a method such as RIE (Reactive Ion Etching), removal of the silicon nitride layer in the stacked body MCA_{A}, by a method such as RIE, and slimming of the resist RG1 by a method such as wet etching, are repeatedly executed. This step results in there being formed in each silicon nitride layer in the stacked body MCA_{A} a portion corresponding to the terrace portion (a portion that, viewed from a negative side in the Z-direction, does not overlap another silicon nitride layer). Moreover, repetition of this step results in the stacked body MCA_{A}, being divided every memory cell array MCA (every memory plane MP).

Next, as shown in FIG. 15, the plurality of memory cell arrays MCA are formed. The memory cell array MCA can be formed by the following steps, for example. First, a region between the stacked bodies MCA_{A}, is filled in by the insulating layer 105. Next, a memory hole penetrating the stacked body MCA_{A}, and reaching the conductive layer 100_{A} is formed at a plurality of positions corresponding to the plurality of semiconductor columns 120. Next, the gate insulating film 130, the semiconductor column 120, and so on, are formed in these plurality of memory holes. Next, a trench is formed at a plurality of positions corresponding to the plurality of inter-block insulating layers ST. Next, the silicon nitride layers in the stacked body MCA_{A} are removed by a method such as wet etching via the plurality of trenches, and a plurality of cavities are formed. Next, the plurality of conductive layers 110 are formed by a method such as CVD. Next, the inter-block insulating layer ST is formed inside the trench.

Note that in order to suppress that a later-mentioned GeO elimination reaction progresses in the first layer 162 (FIG. 8) prior to the first layer 162 undergoing later-mentioned irradiation with laser light, the memory cell array MCA is formed at a lower temperature than a progression temperature (of up to 600 degrees, for example) of the GeO elimination reaction.

Next, the wiring layers CH, Vy, M0, M1, MB, and so on, described with reference to the likes of FIGS. 4 and 5, are formed. This step is performed by the likes of a damascene process, for example.

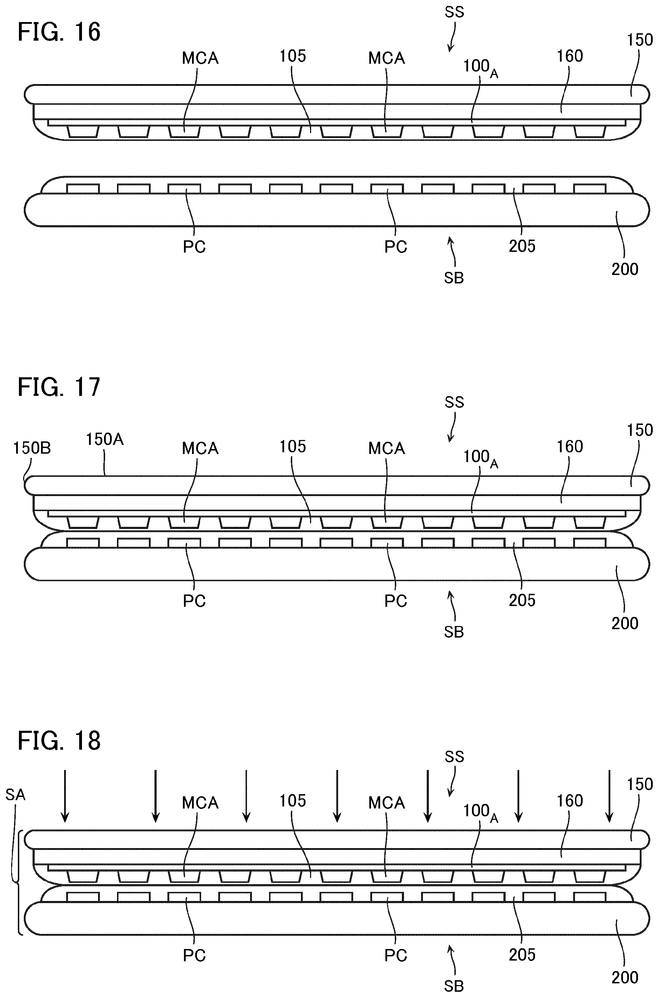

Next, as shown in FIG. 16, a second wafer SB which is a separate body from the first wafer SS, is formed. Specifically, a plurality of the peripheral circuits PC including the transistors Tr (FIG. 5) as a second element, are formed on the semiconductor substrate 200. The respective plurality of peripheral circuits PC are formed so as to correspond to the plurality of memory cell arrays MCA, for example. Moreover, the insulating layer 205 covering the peripheral circuit PC is formed. The bonding electrode P_{I2} electrically connected to the transistor Tr, and so on, of the peripheral circuit PC is formed in a surface of the insulating layer 205.

Next, as shown in FIGS. 16 and 17, the first wafer SS and the second wafer SB are bonded. Specifically, as shown in FIG. 16, a surface where the memory cell arrays MCA, and so on, are formed of the first wafer SS is faced against a surface where the peripheral circuits PC, and so on, are formed of the second wafer SB. Next, as shown in FIG. 17, the first wafer SS and the second wafer SB are bonded. In this step, the insulating layer 105 in the first wafer SS and the insulating layer 205 in the second wafer SB are joined.

Note that when the first wafer SS and the second wafer SB are bonded, the first wafer SS and the second wafer SB are arranged so that the plurality of bonding electrodes P_{I1} and the plurality of bonding electrodes P_{I2} overlap viewed in the Z-direction.

After the insulating layers 105, 205 have been joined, annealing process is performed, whereby both of the bonding electrodes P_{I1}, P_{I2} are joined by Cu-Cu joints, for example.

This results in that along with mutually corresponding memory cell arrays MCA and peripheral circuits PC being electrically connected, the first wafer SS and the second wafer SB are bonded (the first substrate 150 and the semiconductor substrate 200 are bonded via the bonding electrodes P_{I1} and the bonding electrodes P_{I2}). In the following description, a structure where the first wafer SS and the second wafer SB have been bonded will be referred to as a bonded body SA.

As shown in FIG. 17, in the present embodiment, an outer peripheral portion 150B of the first substrate 150 has not undergone trimming processing. Specifically, in the first substrate 150, the outer peripheral portion 150B configuring an outer peripheral portion of a main body portion 150A has a round shape in cross-sectional view. The outer peripheral portion 150B does not have a notched shape in cross-sectional view, and has not undergone trimming processing to form such a notched shape, for example. Such trimming processing need not be performed in a period from the step of preparing the first substrate 150 to the step of bonding the first wafer SS and the second wafer SB, need not be performed up to a later-mentioned reutilization step, and need not be performed over an entirety of manufacturing steps of the semiconductor device, for example.

As shown in FIG. 18, laser light is transmitted through the first substrate 150 to irradiate the first layer 162, in the bonded body SA of the first wafer SS and the second wafer SB. Wavelength of the laser light is preferably in a range of 9.2 to 10.8 µm. A carbon dioxide (CO₂) laser, for example, may be employed as the laser light.

Irradiating mode of the laser light is not particularly limited, but pulse-like irradiation is preferable, for example. As shown in FIG. 19, for example, the bonded body SA of the first wafer SS and the second wafer SB can be placed on a rotationally drivable stage RT, and can sequentially undergo pulse-like irradiation with laser light from a laser oscillator OSC, while the stage RT is rotated.

That is, by irradiating the first wafer SS with laser light at fixed time intervals while rotating the stage RT, it is possible to irradiate with the laser a plurality of positions LR along a certain circle centered on a rotational axis of the stage RT. Moreover, by bringing an irradiating position of the laser closer to the rotational axis of the stage RT or distancing the irradiating position of the laser from the rotational axis of the stage RT, it is possible to irradiate with the laser a plurality of positions LR along another circle centered on the rotational axis of the stage RT. Such a method enables laser light to be irradiated in a concentric circular manner on an entire surface of the first wafer SS.

Pitch of the irradiating position of the laser light can be set to a 10-or-so µm interval, for example. Pulse frequency can be set to between 10 kHz and 100 kHz inclusive, for example.

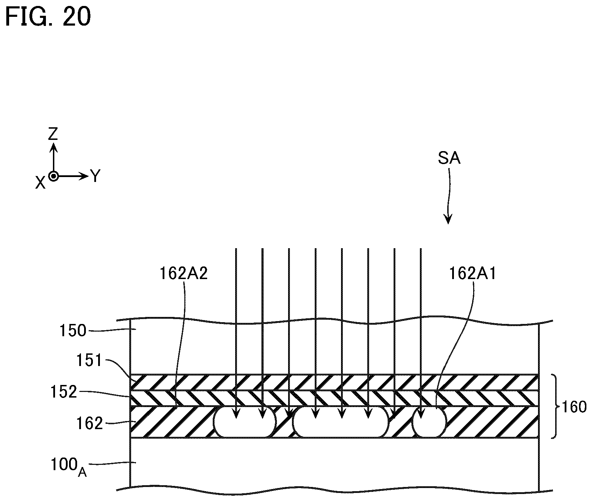

By the first wafer SS being irradiated with laser light, laser light is transmitted through the first substrate 150 and the insulating layers 151, 152, and reaches the first layer 162, as shown in FIG. 20. The laser light that has reached the first layer 162 is absorbed by the first layer 162, and sharply raises temperature of the first layer 162. As a result, the GeO elimination reaction (elimination of germanium monoxide) indicated by equation (1) described below progresses in the first layer 162, whereby GeO gas is generated in the first layer 162.

GeO₂ + Ge → 2GeO ... (1)

Temperature that the first layer 162 is heated by irradiation with the laser light is preferably between 500 degrees and 700 degrees inclusive, more preferably between 550 and 650 degrees inclusive, and even more preferably between 570 degrees and 630 degrees inclusive, from a viewpoint of suitably progressing the GeO elimination reaction. Such a heating temperature may be set to 600 degrees, for example.

Generation of GeO gas in the first layer 162 causes a stress difference to occur between a neighboring portion of where the GeO gas has been generated, and a flanking portion of the neighboring portion. For example, generation of GeO gas in the first layer 162 causes a stress difference to occur between a neighboring portion 162A1 of a portion where GeO gas has been generated in the first layer 162, and a flanking portion 162A2 located in a flank of the neighboring portion 162A1, in the first layer 162 (such a stress difference may also occur in the insulating layers 152, 151, for example). Moreover, due to this stress difference, a strain occurs between the neighboring portion 162A1 and the flanking portion 162A2, and a cleavage occurs in a boundary surface between the first layer 162 and the insulating layer 152, or in the first layer 162 itself, for example.

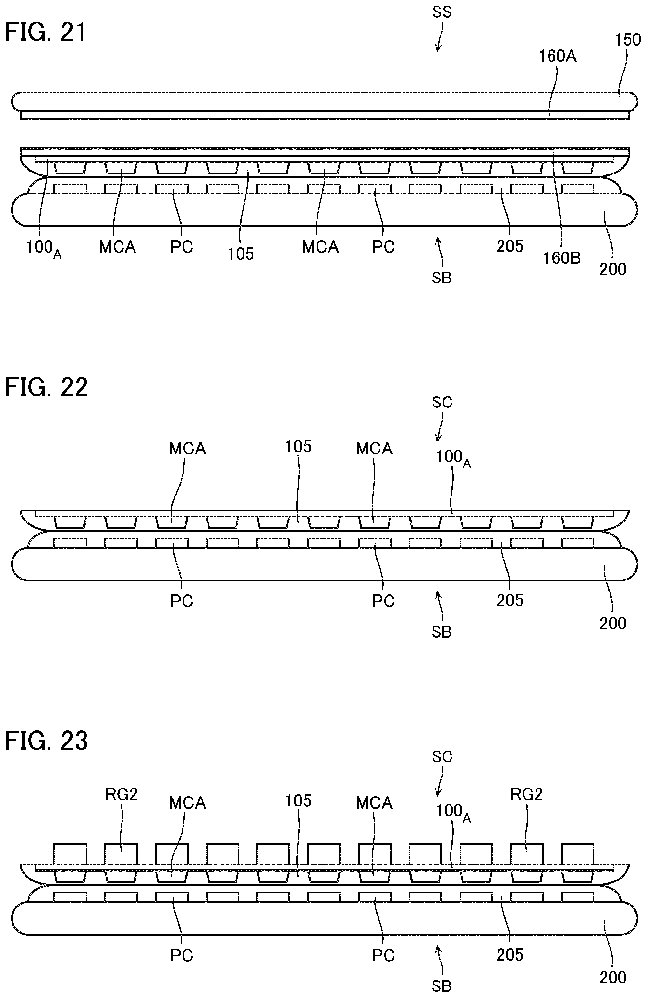

Due to the cleavage that has occurred in this way, as shown in FIG. 21, the first substrate 150 will be detached from other configurations in the first wafer SS (configurations formed later than the first layer 162 in the first wafer SS). At this time, all or parts of the insulating layers 151, 152, and a part of the first layer 162 will accompany the first substrate 150 as an accompanying portion 160A, and will be detached along with the first substrate 150. Moreover, another part of the first layer 162 will remain on a second wafer SB side as a remaining portion 160B. Hereafter, configurations in the first wafer SS remaining on the second wafer SB side will be referred to as a structure SC.

Next, the remaining portion 160B that has remained in the structure SC is ground and removed by the likes of CMP (Chemical Mechanical Polishing). As a result, as shown in FIG. 22, the conductive layer 100_{A} is exposed on an upper surface of the second wafer SB.

Next, as shown in FIG. 23, a resist RG2 having a pattern matched to dispositions of the individual memory cell arrays MCA (memory planes MP) is formed on the conductive layer 100_{A}. When forming the resist RG2, for example, the resist is coated, patterning is performed by a method of the kind described with reference to FIGS. 11 and 12, and a part of the resist is removed by a method such as wet etching.

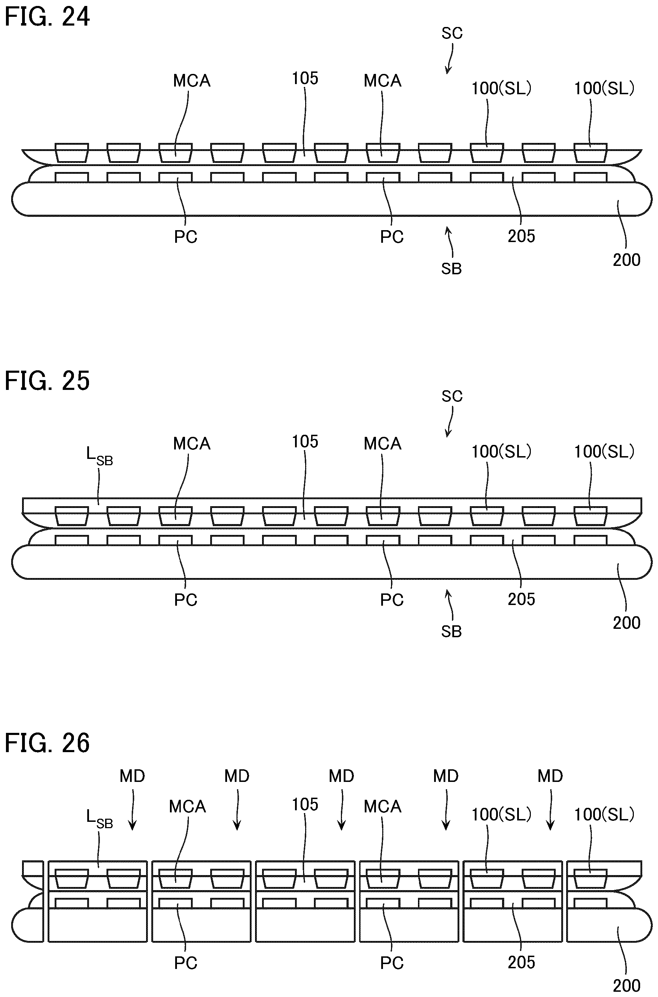

Next, as shown in FIG. 24, etching processing of the conductive layer 100_{A} is performed via the resist RG2, whereby a plurality of the conductive layers 100 (source lines SL) separated every individual memory cell array MCA, are formed.

After the conductive layers 100 have been formed, the resist RG2 is removed by ashing process using oxygen plasma, or the like. Then, as shown in FIG. 25, the substrate layer L_{SB} is formed.

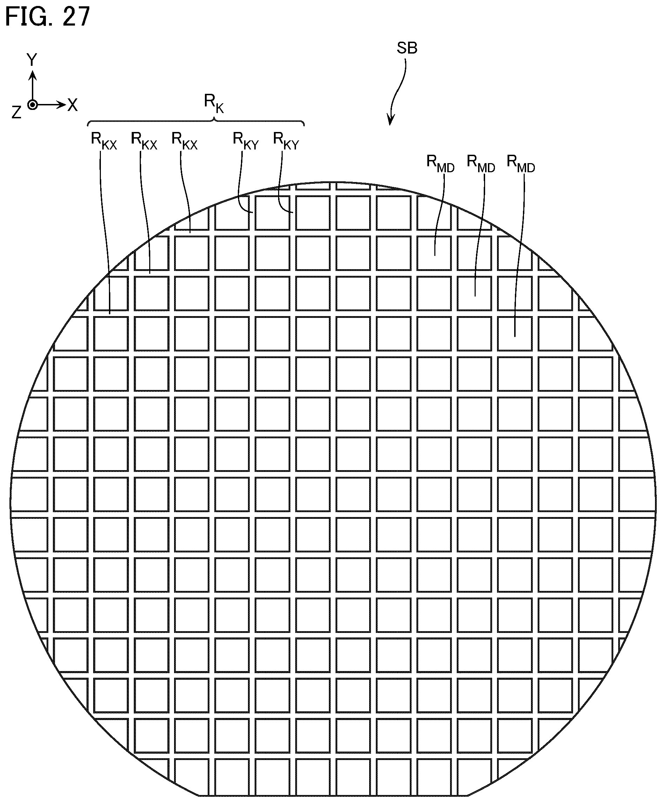

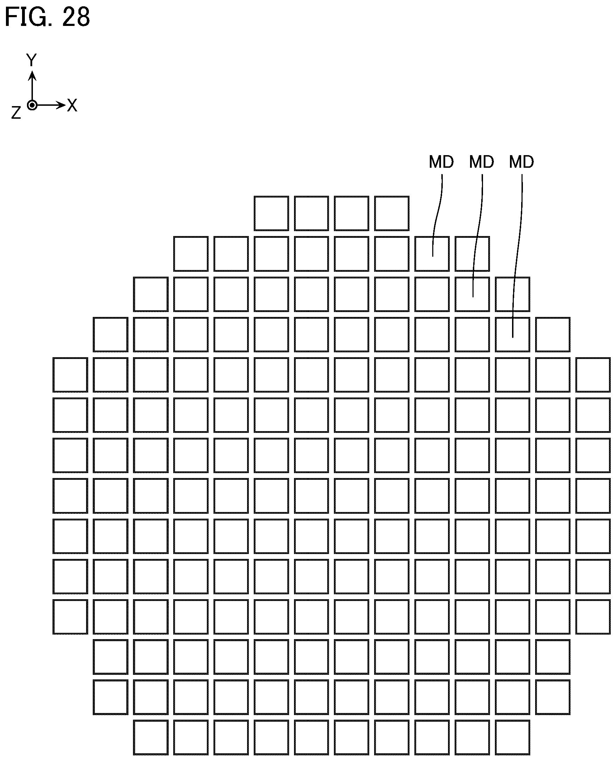

Next, as shown in FIG. 26, individualization is performed, and a plurality of the memory dies MD are formed. That is, the structure SC and the second wafer SB are provided with the plurality of die regions R_{MD}, as shown in FIG. 27, for example. Moreover, the kerf regions R_{KX}, R_{KY} are provided between these plurality of die regions R_{MD}. In the step of individualization, for example, dicing is performed along the dicing lines in the kerf regions R_{KX}, R_{KY}, and, as shown in FIG. 28, a bonded body of the structure SC and the second wafer SB is individualized for each of the plurality of die regions R_{MD}. Each individualized configuration becomes a memory die MD.

Note that for convenience of illustration, in the example of FIG. 3, four memory cell arrays MCA (memory planes MP) are provided in each memory die MD, and in the example of FIG. 26, two memory cell arrays MCA (memory planes MP) are provided in each memory die MD. However, the number of memory cell arrays MCA (memory planes MP) in each memory die MD is appropriately adjustable.

Note that by performing the following reutilization step, the first substrate 150 detached in the step described with reference to FIG. 21 can be employed in manufacturing of a new memory die MD.

In the reutilization step, the accompanying portion 160A accompanying the first wafer SS side due to cleavage of the first layer 162 (refer to FIG. 21) may be removed by being ground using a polishing pad. Moreover, in the reutilization step, the accompanying portion 160A may be removed by the likes of wet etching.

Removing the accompanying portion 160A from the first substrate 150, and then re-executing the step described with reference to FIG. 8 and subsequent steps makes it possible for the first substrate 150 to be used a plurality of times in manufacturing steps of the memory die MD.

### [Advantages]

In a method of manufacturing a semiconductor device, in the case where a substrate having a certain layer, and another substrate are bonded, and the certain layer is irradiated with a laser light to detach the substrate, there is a possibility that a local stress will occur in the certain layer or its close vicinity, and that a crystalline defect, structural damage, or the like, will occur in the substrate or a structure formed in the substrate. Moreover, in the case where, after a step of detaching the two substrates, it is tentatively attempted to reutilize the substrate that had had the certain layer, there is a need for a portion where the previously-mentioned crystalline defect, structural damage, or the like (hereafter, referred to as damage), has occurred, to be deeply ground, for example, in order to remove it. By doing so, the substrate to be reutilized will get thinner, and the number of times the substrate can be reutilized will fall.

As described with reference to FIG. 8, the method of manufacturing a semiconductor device according to the present embodiment includes a step of stacking the first layer 162 mainly composed of a silicon and including germanium and oxygen on the first substrate 150. Moreover, as described with reference to FIG. 15, it includes a step of forming the memory cell array MCA (first element) and the bonding electrode P_{I1} (first bonding electrode) in the first wafer SS. Moreover, as described with reference to FIG. 16, it includes a step of forming the transistor Tr (second element) and the bonding electrode P_{I2} in the second wafer SB. Moreover, as described with reference to FIG. 17, it includes a step of bonding the first wafer SS and the second wafer SB via the bonding electrode P_{I1} and the bonding electrode P_{I2}. Moreover, as described with reference to FIGS. 18 to 20, it includes a step of transmitting a laser light through the first substrate 150 to irradiate the first layer 162 with the laser light, and thereby inducing cleavage the first layer 162.

Such a configuration makes it possible to cause laser light to be absorbed by the first layer 162 and GeO gas to be thereby generated in the first layer 162, and enables a stress difference to be generated in a periphery of a portion where the GeO gas has been generated, and the first substrate 150 to be suitably detached. As a result, it can be suppressed that damage occurs in the likes of the first substrate 150 or memory cell array MCA (first element) due to detachment of the first substrate 150. Hence, in the case where reutilization of the first substrate 150 is supposed, it can be suppressed that grinding of the first substrate 150 gets deep, and can be suppressed that the number of times the first substrate 150 can be reutilized falls, for example.

Moreover, in the present embodiment, the first substrate 150 is a silicon substrate or a silicon carbide substrate. Such a configuration enables evaporation, and so on, to be effectively caused in the first layer 162, due to laser light being suitably transmitted through the first substrate 150.

Now, if, in the case of a bonded body obtained by bonding a wafer including a memory cell array MCA and wafer including a peripheral circuit PC, a substrate in the wafer including the memory cell array MCA is removed from the bonded body by being ground, then there is a risk of a thickness of an outer peripheral portion of the substrate getting extremely thin, and the outer peripheral portion breaking midway through the grinding. Therefore, there is a technology where trimming processing is priorly performed on the outer peripheral portion to suppress breakage of the outer peripheral portion.

On the other hand, in the present embodiment, since the first layer 162 is cleaved by laser light being irradiated on the first layer 162, a step for grinding the first substrate 150 to remove it, is not included. Hence, the outer peripheral portion 150B of the first substrate 150 does not undergo trimming processing.

Such a configuration enables the semiconductor device to be efficiently manufactured since a step of performing trimming processing of the outer peripheral portion 150B of the first substrate 150 is not required.

Moreover, as described with reference to FIG. 8, in the present embodiment, the insulating layers 151, 152 are stacked on the first substrate 150, prior to the first layer 162 being stacked on the first wafer SS.

Such a configuration enables extension of damage to the first substrate 150 with generation of GeO gas in the first layer 162 or cleavage of the first layer 162, to be more suitably suppressed by the insulating layers 151, 152. Moreover, it enables transmission to the first substrate 150 of heat generated by laser light being absorbed by the first layer 162 to be suppressed.

Moreover, the gate insulating film 130 includes the ferroelectric film mainly composed of at least one of silicon, aluminum, hafnium, and zirconium.

Such a configuration makes it possible to configure a memory cell array MCA where it can be suppressed that the GeO elimination reaction progresses in the first layer 162 prior to the step of irradiating the first layer 162 with laser light to induce cleavage in the first layer 162, being performed.

### [Second Embodiment]

The method of manufacturing a semiconductor device according to the first embodiment can be appropriately adjusted. A step of reutilizing the first substrate 150 to manufacture a memory die MD2 will be described below as a second embodiment. Note that in the second embodiment, identical symbols will be employed for parts the same as in the first embodiment, and duplicated descriptions of structures, steps, actions, and advantages of those parts will be omitted.

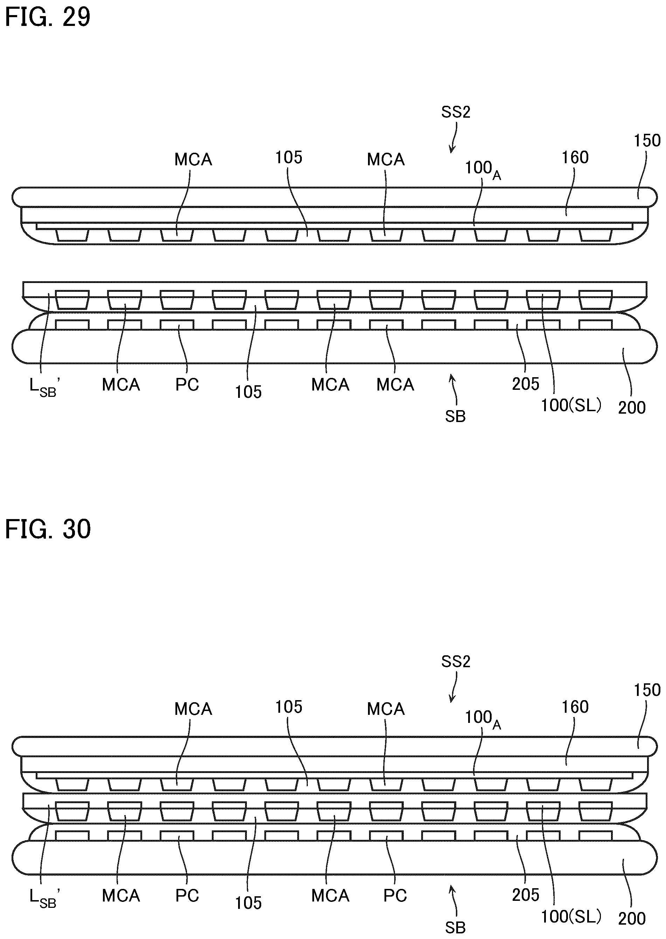

FIGS. 29 to 33 are schematic cross-sectional views for explaining a method of manufacturing a semiconductor device according to the second embodiment.

The method of manufacturing a semiconductor device according to the second embodiment executes up to the step described with reference to FIG. 25 of the method of manufacturing a semiconductor device according to the first embodiment. However, in the step described with reference to FIG. 25, a substrate layer L_{SB}' is formed instead of the substrate layer L_{SB}. The substrate layer L_{SB}' is basically configured similarly to the substrate layer L_{SB}. However, an upper surface of the substrate layer L_{SB}' has formed therein a configuration similar to the bonding electrodes P_{I1}, P_{I2}, instead of the external pad electrode P_{X}.

Next, steps similar to the steps described with reference to FIGS. 8 to 16 are executed, and a wafer SS2 is formed. The wafer SS2 comprises a similar structure to the first wafer SS.

Next, as shown in FIGS. 29 and 30, the substrate layer L_{SB}' and the wafer SS2 are bonded. This step is executed similarly to the steps described with reference to FIGS. 16 and 17.

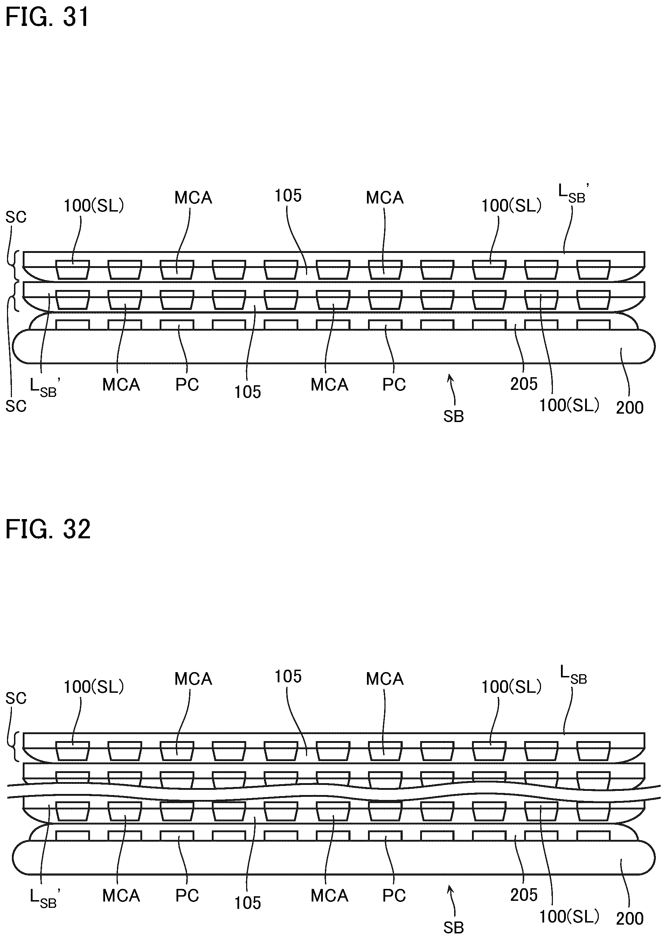

Next, steps similar to the steps described with reference to FIGS. 18 to 25 are executed. However, in the step described with reference to FIG. 25, the substrate layer L_{SB}' is formed instead of the substrate layer L_{SB}. As a result, as shown in FIG. 31, a bonded body of a first structure SC bonded to the upper surface of the second wafer SB, and a second structure SC bonded to an upper surface of this first structure SC, is formed.

Similarly, thereafter, steps similar to the steps described with reference to FIGS. 8 to 25 are repeatedly executed, whereby, as shown in FIG. 32, a bonded body of a plurality of the structures SC bonded to the second wafer SB, is formed.

Next, steps similar to the steps described with reference to FIGS. 26 to 28 are executed, the bonded body of the plurality of structures SC bonded to the second wafer SB undergoes individualization, and a plurality of the memory dies MD2 are formed.

### [Third Embodiment]

A configuration of the stacked portion 160 according to the first embodiment can be appropriately adjusted. A stacked portion 360 being a different configuration from the stacked portion 160 will be described below as a third embodiment. Note that in the third embodiment, identical symbols will be employed for parts the same as in the first embodiment, and duplicated descriptions of structures, steps, actions, and advantages of those parts will be omitted.

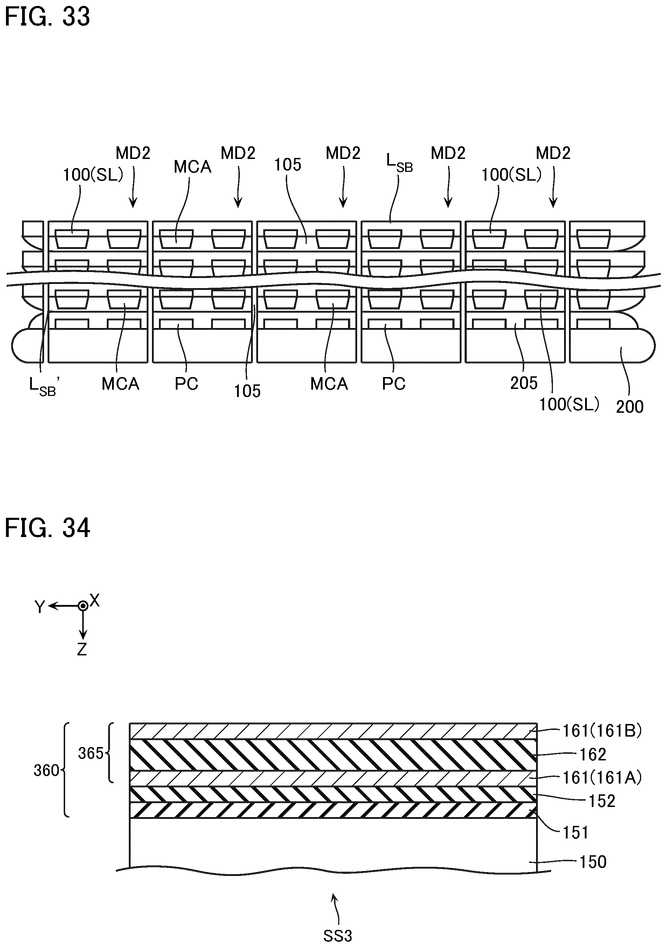

FIG. 34 is a schematic cross-sectional view for explaining a method of manufacturing a semiconductor device according to the third embodiment.

The method of manufacturing a semiconductor device according to the third embodiment is basically executed similarly to the method of manufacturing a semiconductor device according to the first embodiment. However, in the third embodiment, in a step corresponding to FIG. 8, the stacked portion 360 is formed instead of the stacked portion 160.

Specifically, as shown in FIG. 34, the stacked portion 360 is formed by stacking a layer 161 on a surface of the insulating layer 152, stacking the first layer 162 on a surface of the layer 161, and re-stacking the layer 161 on a surface of the first layer 162. A portion where the layers 161 and first layer 162 are stacked in the stacked portion 360, will be referred to as a multi-stacked portion 365.

In the example of FIG. 34, the multi-stacked portion 365 comprises two layers 161 and one first layer 162. The first layer 162 is sandwiched by the layers 161 in the Z-direction. In the multi-stacked portion 365, the layer 161 first counting in order from a positive side in the Z-direction (first substrate 150 side) is assumed to be a second layer 161A, and the layer 161 second counting in order from a positive side in the Z-direction (first substrate 150 side) is assumed to be a third layer 161B.

The second layer 161A and the third layer 161B have higher Young's moduli than the first layer 162. Young's moduli of the first layer 162, the second layer 161A, and the third layer 161B are not particularly limited, but there may be adopted a configuration where, for example, Young's modulus of the first layer 162 is about 190 GPa, and Young's moduli of the second layer 161A and the third layer 161B are about 310 GPa.

Moreover, the second layer 161A and the third layer 161B include a compound including at least one of tungsten (W), titanium (Ti), and silicon (Si). Moreover, the second layer 161A and the third layer 161B may include a metal compound having light transmittance. For example, the second layer 161A and the third layer 161B may include at least one of tungsten oxide (WO₃), titanium oxide (TiO₂), and silicon nitride (SiN).

Moreover, melting points of the second layer 161A and the third layer 161B may be higher than a melting point of the first layer 162. Such a configuration enables it to be suppressed that the second layer 161A or the third layer 161B melt when the first layer 162 is irradiated with laser light to generate GeO gas. Moreover, it enables extension of damage to the first substrate 150 or memory cell array MCA (first element) to be suppressed by the second layer 161A or the third layer 161B.

A layer thickness of the second layer 161A and the third layer 161B is not particularly limited, but may be set to 300 nm or less, may be set to 200 nm or less, and may be preferably set to between 50 nm and 100 nm inclusive.

A film-forming method of the second layer 161A and the third layer 161B is not particularly limited, but examples of the film-forming method include CVD, PVD (Physical Vapor Deposition) of the likes of sputtering, and so on. Note that materials of the second layer 161A and the third layer 161B may be identical, or may differ.

Subsequently, in a step of irradiating with laser light a first wafer SS3 comprising the stacked portion 360 (refer to FIGS. 18 and 20), laser light is transmitted through the first substrate 150, the insulating layers 151, 152, and the second layer 161A, and reaches the first layer 162. The laser light that has reached the first layer 162 is absorbed by the first layer 162, and sharply raises temperature of the first layer 162. As a result, the GeO elimination reaction indicated by equation (1) described above progresses, whereby GeO gas is generated, and a cleavage occurs in the first layer 162.

Due to the above kind of configuration, the layers 161 (second layer 161A and third layer 161B) are provided on upper and lower surfaces of the first layer 162, so it is possible for cracking, or the like, that has occurred in the first layer 162 due to cleavage in the first layer 162 to be stopped by the second layer 161A or the third layer 161B, and it can be further suppressed by the second layer 161A or the third layer 161B that damage extends to the first substrate 150 or a first element MCA. Hence, in the case where the first substrate 150 is reutilized, it can be further suppressed that grinding of the first substrate 150 gets deep, and can be further suppressed that the number of times the substrate 150 can be reutilized falls, for example. Moreover, by the first layer 162 being disposed between the second layer 161A and the third layer 161B, a part of the laser light that has been transmitted through the second layer 161A on an upper side will be reflected by the third layer 161B on a lower side, or there will be interference between this reflected laser light and laser light that is transmitted through the second layer 161A on the upper side, hence enabling the laser light to be effectively absorbed in the first layer 162.

### [Fourth Embodiment]

Next, yet another configuration will be exemplified for the stacked portion 160 according to the first embodiment. A stacked portion 460 being a different configuration from the stacked portion 160 will be described below as a fourth embodiment. Note that in the fourth embodiment, identical symbols will be employed for parts the same as in the first embodiment, and duplicated descriptions of structures, steps, actions, and advantages of those parts will be omitted.

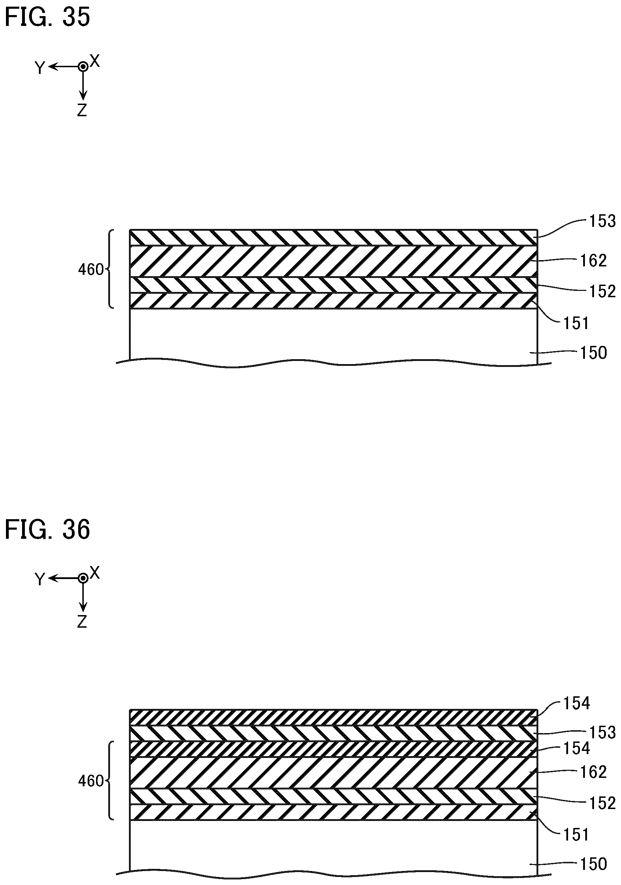

FIG. 35 is a schematic cross-sectional view for explaining a method of manufacturing a semiconductor device according to the fourth embodiment.

The method of manufacturing a semiconductor device according to the fourth embodiment is basically executed similarly to the method of manufacturing a semiconductor device according to the first embodiment. However, in the fourth embodiment, in a step corresponding to FIG. 8, the stacked portion 460 is formed instead of the stacked portion 160.

Specifically, as shown in FIG. 35, the first layer 162 is stacked on the first wafer SS, and then a reflecting layer 153 that reflects laser light is stacked on the first wafer SS. The reflecting layer 153, which is a layer whose reflectance is higher than that of the first layer 162, may include at least one of tungsten (W), molybdenum (Mo), a titanium-tungsten alloy (TiW), titanium (Ti), and titanium nitride (TiN), for example.

Such a configuration results in that in the step described with reference to FIG. 18, the laser light that has been transmitted through the first layer 162 without being absorbed by the first layer 162 can be reflected by the reflecting layer 153 and be incident again on the first layer 162, thereby more suitably generating heat.

Note that a configuration of the stacked portion 460, too, is appropriately adjustable.

FIG. 36 is a schematic cross-sectional view for explaining a method of manufacturing a semiconductor device according to the fourth embodiment. When forming the stacked portion 460, as shown in FIG. 36, for example, a diffusion-preventing barrier metal layer 154 may be formed above and below the reflecting layer 153. The barrier metal layer 154 includes titanium nitride (TiN), for example.

### [Fifth Embodiment]

In the first through third embodiments, a FeFET or NAND flash memory has been exemplified as the semiconductor device being manufactured. However, technology described in the present specification can also be applied to a configuration other than NAND flash memory, such as NOR flash memory, for example. Moreover, technology described in the present specification can also be applied to a configuration other than flash memory, such as DRAM, for example.

An example where technology described up to now is applied to DRAM will be described below as a fifth embodiment.

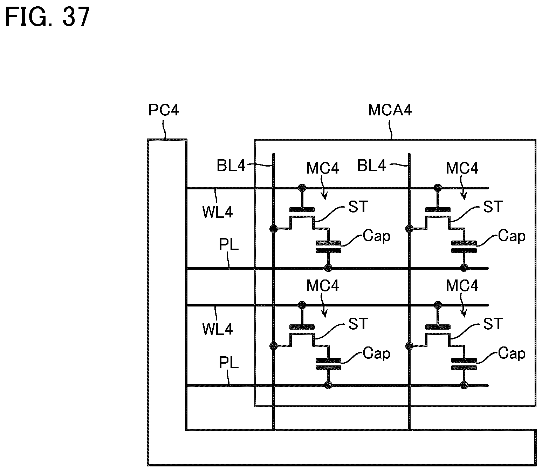

FIG. 37 is a schematic circuit diagram showing a part of a configuration of a semiconductor device according to the fifth embodiment. The semiconductor device according to the fifth embodiment comprises a memory cell array MCA4 and a peripheral circuit PC4 of the kind shown in FIG. 37, for example.

The memory cell array MCA4 comprises: a plurality of bit lines BL4; a plurality of word lines WL4; a plurality of plate lines PL; and a plurality of memory cells MC4 connected to these plurality of bit lines BL4, plurality of word lines WL4, and plurality of plate lines PL. The respective plurality of memory cells MC4 connected to one word line WL4 are connected to mutually differing bit lines BL4. Moreover, the respective plurality of memory cells MC4 connected to one bit line BL4 are connected to mutually differing word lines WL4.

The memory cells MC4 each comprise a select transistor ST and a capacitor Cap connected in series between the bit line BL4 and the plate line PL.

The select transistor ST is a field effect type transistor which comprises a semiconductor layer functioning as a channel region, and comprises a gate insulating film and a gate electrode. The respective gate electrodes of the select transistors ST are connected with the word lines WL4.

The capacitor Cap comprises a pair of electrodes and an insulating film. The capacitor Cap functions as a memory portion.

The peripheral circuit PC4 comprises, for example, the likes of: a voltage generating circuit that generates operating voltages to be outputted to voltage supply lines; a decode circuit that causes a desired voltage supply line to be electrically conductive with each wiring (bit line BL4, word line WL4, and plate line PL) in the memory cell array MCA4; and a sense amplifier circuit that detects current or voltage of the bit line BL4.

Next, a structure of the semiconductor device according to the fifth embodiment will be described. The semiconductor device according to the fifth embodiment is basically configured similarly to the semiconductor device according to the first embodiment. However, the chip C_{M} of the semiconductor device according to the fifth embodiment includes the memory cell array MCA4 instead of the memory cell array MCA. Moreover, the chip C_{P} of the semiconductor device according to the fifth embodiment includes the peripheral circuit PC4 instead of the peripheral circuit PC.

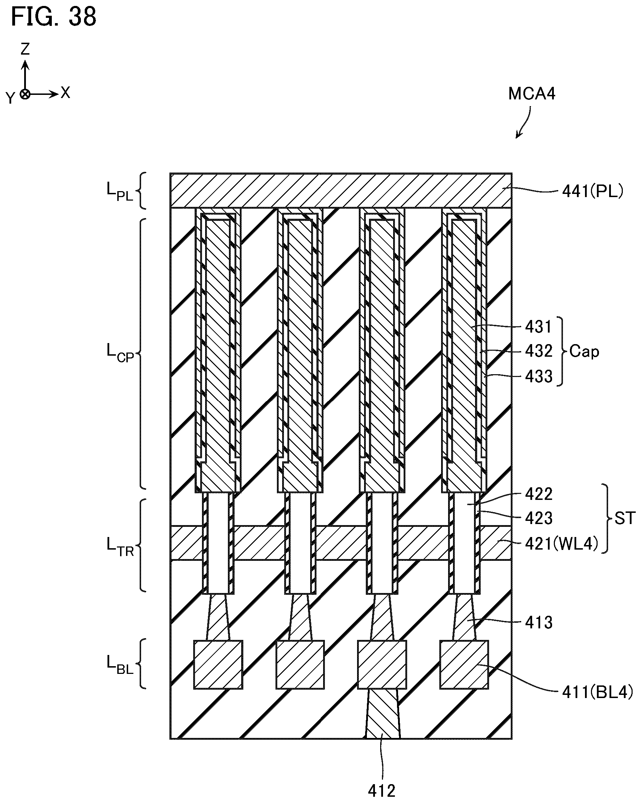

FIG. 38 is a schematic cross-sectional view showing a part of a configuration of the semiconductor device according to the fifth embodiment. FIG. 38 shows a part of a configuration of the chip C_{M} of the semiconductor device according to the fifth embodiment.

As shown in FIG. 38, the chip C_{M} of the semiconductor device according to the fifth embodiment comprises a bit line layer L_{BL}, a transistor layer L_{TR}, a capacitor layer L_{CP}, and a plate line layer L_{PL} provided in order from below to above.

The bit line layer L_{BL} comprises a plurality of wirings 411 arranged in the X-direction and extending in the Y-direction. The wiring 411 functions as the bit line BL4. A lower surface of the wiring 411 is connected with an upper end of a via contact electrode 412, and an upper surface of the wiring 411 is connected with a lower end of a via contact electrode 413. The wiring 411 is connected to the bonding electrode P_{I1} of the kind described with reference to FIGS. 4 and 5, via the via contact electrode 412.

The transistor layer L_{TR} comprises: a plurality of wirings 421 arranged in the Y-direction and extending in the X-direction; a plurality of semiconductor columns 422 arranged in the X-direction and the Y-direction correspondingly to the wirings 411, 421, electrically connected to the wiring 411, and facing the wiring 421; and a plurality of insulating layers 423 provided on a surface facing the wiring 421 of the semiconductor column 422.

The wiring 421 functions as the gate electrodes of the plurality of select transistors ST arranged in the X-direction, and as the word line WL4 (FIG. 37). The wiring 421 may include the likes of tungsten (W) or a stacked structure of titanium nitride (TiN) and tungsten (W), for example.

The semiconductor column 422 functions as a channel region of the select transistor ST (FIG. 37), for example. The semiconductor column 422 extends in the Z-direction, and has a substantially circular column-like shape, for example. Outer peripheral surfaces of a plurality of the semiconductor columns 422 arranged in the X-direction are surrounded by the same wiring 421, and face this wiring 421. A lower end of the semiconductor column 422 is electrically connected to the wiring 411 via the via contact electrode 413.

The semiconductor column 422 includes an oxide semiconductor. The semiconductor column 422 includes for example: at least one element selected from the group consisting of indium (In), gallium (Ga), zinc (Zn), magnesium (Mg), aluminum (Al), calcium (Ca), titanium (Ti), manganese (Mn), cadmium (Cd), and tin (Sn); zinc (Zn); and oxygen (O). The semiconductor column 422 includes indium (In), gallium (Ga), zinc (Zn), and oxygen (O), for example.

The insulating layer 423 functions as the gate insulating film of the select transistor ST (FIG. 37). The insulating layer 423 extends in the Z-direction along the outer peripheral surface of the semiconductor column 422, and insulates the semiconductor column 422 and the wiring 421. The insulating layer 423 may be of silicon oxide (SiO₂) or silicon nitride (SiN), or may be a stacked film of these and another high dielectric constant insulating layer, for example.

The capacitor layer L_{CP} comprises: a plurality of conductive columns 431 arranged in the X-direction and the Y-direction correspondingly to the plurality of semiconductor columns 422; an insulating layer 432 extending in the Z-direction along an outer peripheral surface of the conductive column 431; and a conductive layer 433 extending in the Z-direction along an outer peripheral surface of the insulating layer 432.

The conductive column 431 functions as a part of one electrode of the capacitor Cap (FIG. 37). The conductive column 431 extends in the Z-direction, and is connected at its lower end to an upper end of the semiconductor column 422. The conductive column 431 includes the likes of a stacked structure of titanium nitride (TiN) and tungsten (W), for example.

The insulating layer 432 functions as an inter-electrode insulating layer of the capacitor Cap (FIG. 37). The insulating layer 432 includes the likes of aluminum oxide (AlO), for example. The insulating layer 432 may be of silicon oxide (SiO₂) or another insulating metal oxide, for example.

The conductive layer 433 functions as the other electrode of the capacitor Cap (FIG. 37), for example. The conductive layer 433 faces the outer peripheral surface of the conductive column 431, via the insulating layer 432. The conductive layer 433 includes the likes of a stacked structure of titanium nitride (TiN) and tungsten (W), for example.

The plate line layer L_{PL} comprises a conductive layer 441 connected to upper ends of the plurality of conductive layers 433 arranged in the X-direction and the Y-direction. The conductive layer 441 functions as the plate line PL (FIG. 37), for example. The conductive layer 441 may include the likes of tungsten (W) or a stacked structure of titanium nitride (TiN) and tungsten (W), for example.

When manufacturing the semiconductor device according to the fifth embodiment, the step described with reference to FIG. 8 is executed to form the stacked portion 160 in the first wafer SS. Next, configurations in the plate line layer L_{PL}, configurations in the capacitor layer L_{CP}, configurations in the transistor layer L_{TR}, and configurations in the bit line layer L_{BL} described with reference to FIG. 38, are formed on the stacked portion 160. Next, the bonding electrodes P_{I1}, and so on, described with reference to FIG. 4 are manufactured.

Next, a wafer including the peripheral circuit PC4 instead of the peripheral circuit PC is formed as the second wafer SB. Subsequently, the steps from the steps described with reference to FIGS. 16 and 17 onward, of the method of manufacturing a semiconductor device according to the first embodiment are executed, whereby the semiconductor device according to the fifth embodiment is formed.

### [Sixth Embodiment]

In the fifth embodiment, DRAM has been exemplified as the semiconductor being manufactured. Now, it is possible for a variety of structures to be applied as structure of DRAM.

An example where technology described up to now is applied to another structure of DRAM will be described below as a sixth embodiment.

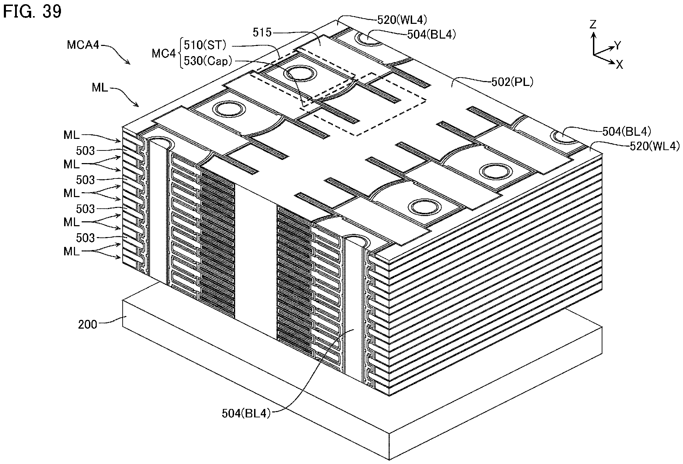

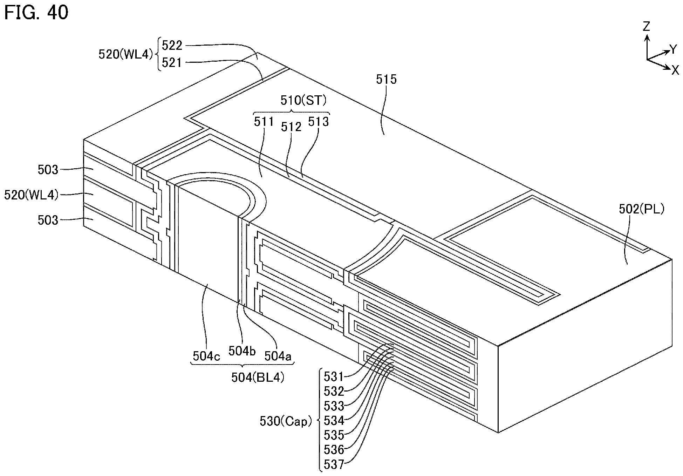

FIGS. 39 and 40 are schematic perspective views showing a part of a configuration of a semiconductor device according to the sixth embodiment. FIG. 40 shows an enlarged part of FIG. 39.

The memory cell array MCA4 according to the sixth embodiment comprises a plurality of memory layers ML arranged in the Z-direction. Moreover, an insulating layer 503 of the likes of silicon oxide (SiO₂) are provided between the respective plurality of memory layers ML.

Moreover, the memory cell array MCA4 according to the sixth embodiment is provided with a conductive layer 502. The conductive layer 502 extends in the Y-direction and the Z-direction, and divides the memory layer ML in the X-direction.

The conductive layer 502 includes the likes of a stacked structure of titanium nitride (TiN) and tungsten (W), for example. The conductive layer 502 functions as the plate line PL (FIG. 37), for example.

In addition, the memory cell array MCA4 is provided with a plurality of via wirings 504. The plurality of via wirings 504 are arranged in the Y-direction, and extend in the Z-direction penetrating the plurality of memory layers ML.

As shown in FIG. 40, the via wiring 504 includes, for example: a conductive oxide film 504a including a conductive oxide; a barrier conductive film 504b of the likes of titanium nitride (TiN); and a conductive member 504c of the likes of tungsten (W). Note that the via wiring 504 may include ruthenium (Ru), iridium (Ir), or another metal, instead of the conductive oxide film 504a. Moreover, the via wiring 504 may include solely a conductive oxide, or may include solely ruthenium (Ru), iridium (Ir), or another metal.

In the present embodiment, a "conductive oxide" will be assumed to include indium tin oxide (ITO), indium zinc oxide (IZO), ruthenium oxide (RuO₂), iridium oxide (IrO₂), or another conductive material including oxygen, for example.

The conductive member 504c comprises a substantially circular column-like shape extending in the Z-direction. The barrier conductive film 504b comprises a substantially cylindrical shape extending in the Z-direction along an outer peripheral surface of the conductive member 504c. The conductive oxide film 504a comprises a substantially cylindrical shape extending in the Z-direction along an outer peripheral surface of the barrier conductive film 504b. The via wiring 504 functions as the bit line BL4 (FIG. 37), for example.

The memory layer ML comprises: a plurality of transistor structures 510 provided correspondingly to the plurality of via wirings 504; a conductive layer 520 provided on an opposite side to the conductive layer 502 with respect to the plurality of transistor structures 510; and a plurality of capacitor structures 530 provided between the plurality of transistor structures 510 and the conductive layer 502.

As shown in FIG. 40, for example, the transistor structure 510 comprises: a semiconductor layer 511 connected to an outer peripheral surface of the via wiring 504 and extending in the X-direction; an insulating layer 512 provided on an upper surface, a lower surface, both side surfaces in the Y-direction, and a side surface on one side in the X-direction (conductive layer 520 side) of the semiconductor layer 511; and a conductive layer 513 provided on an upper surface, a lower surface, both side surfaces in the Y-direction, and a side surface on one side in the X-direction (conductive layer 520 side) of the insulating layer 512.

In an XY cross section at a height position including the semiconductor layer 511, a side surface on one side in the X-direction (conductive layer 502 side) of the semiconductor layer 511 may be formed along a circle centered on a center position of the via wiring 504. Moreover, side surfaces on the other side in the X-direction (conductive layer 520 side) of the semiconductor layer 511, insulating layer 512, and conductive layer 513 may be formed linearly along a side surface of the conductive layer 520. Moreover, both side surfaces in the Y-direction of the semiconductor layer 511, insulating layer 512, and conductive layer 513 may be formed linearly along a side surface of an insulating layer 515.

The semiconductor layer 511 functions as the channel region of the select transistor ST (FIG. 37), for example. The semiconductor layer 511 may be, for example, a semiconductor including: at least one element out of gallium (Ga) and aluminum (Al); indium (In); zinc (Zn); and oxygen (O), or may be, for example, another oxide semiconductor. A plurality of the semiconductor layers 511 arranged in the Z-direction are commonly connected to the via wiring 504 extending in the Z-direction.

The insulating layer 512 functions as the gate insulating film of the select transistor ST (FIG. 37), for example. The insulating layer 512 includes the likes of silicon oxide (SiO₂), for example.

The conductive layer 513 functions as the gate electrode of the select transistor ST (FIG. 37), for example. The conductive layer 513 includes titanium nitride (TiN) or a conductive oxide such as indium tin oxide (ITO), for example. A plurality of the conductive layers 513 arranged in the Y-direction are commonly connected to the conductive layer 520 extending in the Y-direction (refer to FIG. 39). The conductive layer 513 faces the upper surface, the lower surface, both side surfaces in the Y-direction, and the side surface on one side in the X-direction (conductive layer 520 side) of the semiconductor layer 511, via the insulating layer 512.

The insulating layer 515 of the likes of silicon oxide (SiO₂) is provided between two of the semiconductor layers 511 adjacent in the Y-direction. The insulating layer 515 extends in the Z-direction penetrating the plurality of memory layers ML.

The conductive layer 520 functions as the word line WL4 (FIG. 37), for example. The conductive layer 520 extends in the Y-direction, and is connected to a plurality of the conductive layers 513 arranged in the Y-direction. The conductive layer 520 comprises: a barrier conductive film 521 of the likes of titanium nitride (TiN); and a conductive film 522 of tungsten (W), for example.

As shown in FIG. 40, for example, the capacitor structure 530 comprises: a conductive layer 531; a conductive layer 532 provided on an upper surface, a lower surface, both side surfaces in the Y-direction, and a side surface on one side in the X-direction (transistor structure 510 side) of the conductive layer 531; an insulating layer 533 provided on an upper surface, a lower surface, both side surfaces in the Y-direction, and a side surface on one side in the X-direction (transistor structure 510 side) of the conductive layer 532; a conductive layer 534 provided on an upper surface, a lower surface, both side surfaces in the Y-direction, and a side surface on one side in the X-direction (transistor structure 510 side) of the insulating layer 533; an insulating layer 535 provided on an upper surface, a lower surface, and both side surfaces in the Y-direction of the conductive layer 534; a conductive layer 536 provided on an upper surface, a lower surface, and both side surfaces in the Y-direction of the insulating layer 535; and a conductive layer 537 provided on an upper surface, a lower surface, and both side surfaces in the Y-direction of the conductive layer 536.

The conductive layers 531, 532, 536, 537 function as the one electrode of the capacitor Cap (FIG. 37). The conductive layers 531, 537 include the likes of tungsten (W), for example. The conductive layers 532, 536 include the likes of titanium nitride (TiN), for example. The conductive layers 531, 532, 536, 537 are connected to the conductive layer 502.

The insulating layers 533, 535 function as the insulating layer of the capacitor Cap (FIG. 37). The insulating layers 533, 535 may be of zirconia (ZrO₂), alumina (Al₂O₃), or another insulating metal oxide, for example. Moreover, the insulating layers 533, 535 may each be for example a stacked film of a plurality of insulating metal oxides (for example, a stacked film of zirconia and alumina).

The conductive layer 534 functions as the other electrode of the capacitor Cap (FIG. 37), for example. The conductive layer 534 includes a conductive oxide such as indium tin oxide (ITO), for example. The conductive layer 534 is insulated from the conductive layers 531, 532, 536, 537 via the insulating layers 533, 535. The conductive layer 534 is connected to a side surface in the X-direction of the semiconductor layer 511.

When manufacturing the semiconductor device according to the sixth embodiment, the step described with reference to FIG. 8 is executed to form the stacked portion 160 in the first wafer SS. Next, the plurality of memory layers ML and the insulating layers 503 (FIG. 39) are formed on the stacked portion 160. Next, the bonding electrodes P_{I1}, and so on, described with reference to FIG. 4 are manufactured.

Next, the wafer including the peripheral circuit PC4 instead of the peripheral circuit PC is formed as the second wafer SB. Subsequently, the steps from the steps described with reference to FIGS. 16 and 17 onward, of the method of manufacturing a semiconductor device according to the first embodiment are executed, whereby the semiconductor device according to the sixth embodiment is formed.

### [Other Embodiments]

That concludes description of the methods of manufacturing a semiconductor device according to the first through sixth embodiments. However, these configurations are merely exemplifications, and specific configurations can be appropriately adjusted.

For example, the third embodiment has exemplified the stacked portion 360 comprising two layers 161 (second layer 161A and third layer 161B) and one first layer 162. However, the number of first layers 162 and the layers 161 in the stacked portion can be appropriately changed. For example, the stacked portion may be configured having three or more layers 161 and two or more first layers 162 alternately stacked on the insulating layer 152.

Moreover, in the above embodiments, a semiconductor memory device has been exemplified as the semiconductor device being manufactured. However, technology described in the present specification can also be applied to a configuration other than a semiconductor memory device, such as an arithmetic unit.

Note that in the above embodiments, the following item 1 has been disclosed.

### [Item 1]

A method of manufacturing a semiconductor device, including the steps of:
stacking a first layer mainly composed of silicon and including germanium and oxygen on a first wafer having a first substrate;
forming a first element and a first bonding electrode in the first wafer;
forming a second element and a second bonding electrode in a second wafer;
bonding the first wafer and the second wafer via the first bonding electrode and the second bonding electrode; and
transmitting a laser light through the first substrate to irradiate the first layer with the laser light, and thereby induce cleavage in the first layer.

Furthermore, in the fifth embodiment, the following items 2 to 5 have been disclosed.

### [Item 2]

The method of manufacturing a semiconductor device according to item 1, wherein
the first element comprises:
a second semiconductor column extending in a first direction intersecting the first substrate;
a second gate electrode facing an outer peripheral surface of the second semiconductor column;
a second gate insulating film provided between the second semiconductor column and the second gate electrode;
a first electrode connected to one end in the first direction of the second semiconductor column and extending in the first direction;
a dielectric layer extending in the first direction along an outer peripheral surface of the first electrode; and
a second electrode extending in the first direction along an outer peripheral surface of the dielectric layer, and facing the outer peripheral surface of the first electrode via the dielectric layer.

### [Item 3]

The method of manufacturing a semiconductor device according to item 2, wherein
the second gate insulating film includes oxygen and silicon.

### [Item 4]

The method of manufacturing a semiconductor device according to item 2 or 3, wherein
the second semiconductor column includes an oxide semiconductor.

### [Item 5]

The method of manufacturing a semiconductor device according to item 4, wherein
the oxide semiconductor is mainly composed of at least one of titanium and indium.

Various embodiments are in accordance with the following numbered clauses.

Clause 1. A method of manufacturing a semiconductor device (MD), including the steps of:
stacking a first layer (162) mainly composed of silicon and including germanium and oxygen on a first wafer (SS) having a first substrate (150);
forming a first element (MCA) and a first bonding electrode (P_{I1}) in the first wafer;
forming a second element (Tr) and a second bonding electrode (P_{I2}) in a second wafer (SB);
bonding the first wafer and the second wafer via the first bonding electrode and the second bonding electrode; and
transmitting a laser light through the first substrate to irradiate the first layer with the laser light, and thereby induce cleavage the first layer.

Clause 2. The method of manufacturing a semiconductor device according to Clause 1, wherein
the first substrate is a silicon substrate or a silicon carbide substrate.

Clause 3. The method of manufacturing a semiconductor device according to Clause 1 or 2, wherein
the first layer is polycrystalline.

Clause 4. The method of manufacturing a semiconductor device according to any preceding Clause, wherein
the first layer includes germanium dioxide.

Clause 5. The method of manufacturing a semiconductor device according to any preceding Clause, wherein
an outer peripheral portion (150B) of the first substrate has not undergone trimming processing.

Clause 6. The method of manufacturing a semiconductor device according to any preceding Clause, wherein
prior to the first layer being stacked on the first wafer, a protective layer (151, 152) is stacked on the first substrate.

Clause 7. The method of manufacturing a semiconductor device according to any preceding Clause, wherein
prior to the first layer being stacked on the first wafer, a second layer (161A) whose Young's modulus is higher than that of the first layer is stacked on the first wafer, and
after the first layer has been stacked on the first wafer, a third layer (161B) whose Young's modulus is higher than that of the first layer is stacked on the first layer.

Clause 8. The method of manufacturing a semiconductor device according to Clause 7, wherein
the second layer is a compound including at least one of tungsten, titanium, and silicon.

Clause 9. The method of manufacturing a semiconductor device according to any preceding Clause, wherein
after the first layer has been stacked on the first wafer, a fourth layer (153) whose reflectance is higher than that of the first layer is stacked on the first wafer.

Clause 10. The method of manufacturing a semiconductor device according to Clause 9, wherein
the fourth layer includes at least one of tungsten (W), molybdenum (Mo), a titanium-tungsten alloy (TiW), titanium (Ti), and titanium nitride (TiN).

Clause 11. The method of manufacturing a semiconductor device according to any preceding Clause, wherein
the first element comprises:
a plurality of semiconductor layers (511) stacked in a first direction intersecting the first substrate;
a plurality of third gate electrodes (513) which are stacked in the first direction correspondingly to the plurality of semiconductor layers, and each face surfaces on one side and the other side in the first direction of one of the plurality of semiconductor layers;
a third gate insulating film (512) provided between the plurality of semiconductor layers and the third gate electrode;
a via wiring (504) which extends in the first direction and is electrically connected to the plurality of semiconductor layers; and
a plurality of memory portions (Cap) which are stacked in the first direction correspondingly to the plurality of semiconductor layers, and are connected to side surfaces in a second direction intersecting the first direction, of the plurality of semiconductor layers.

Clause 12. The method of manufacturing a semiconductor device according to Clause 11, wherein
the plurality of semiconductor layers (511) are each an oxide mainly composed of at least one of titanium and indium.

Clause 13. The method of manufacturing a semiconductor device according to Clause 11 or 12, wherein
the plurality of memory portions are each a capacitor.

Clause 14. The method of manufacturing a semiconductor device according to any preceding Clause, wherein
the first element comprises:
a plurality of first gate electrodes (110) stacked in a first direction intersecting the first substrate;
a first semiconductor column (120) extending in the first direction; and
a first gate insulating film (130) provided between the plurality of first gate electrodes and the first semiconductor column.

Clause 15. The method of manufacturing a semiconductor device according to Clause 14, wherein
the first gate insulating film includes a ferroelectric film (132) mainly composed of at least one of silicon, aluminum, hafnium, and zirconium.

Clause 16. The method of manufacturing a semiconductor device according to Clause 14 or 15, wherein
the first semiconductor column is an oxide mainly composed of at least one of titanium and indium.

Clause 17. The method of manufacturing a semiconductor device according to Clause 14, 15 or 16, wherein
the first gate electrode is mainly composed of at least one of polycrystalline silicon, tungsten, molybdenum, and titanium nitride.

Clause 18. The method of manufacturing a semiconductor device according to any preceding Clause, wherein
a wavelength of the laser light is in a range of 9.2 to 10.8 µm.

Clause 19. The method of manufacturing a semiconductor device according to any preceding Clause, wherein
after the step of inducing cleavage in the first layer, the second wafer is individualized into a plurality of chips.

Clause 20. The method of manufacturing a semiconductor device according to Clause 7 or any Clause dependent thereon, wherein
a melting point of the second layer is higher than a melting point of the first layer.

### [Others]

While certain embodiments have been described, these embodiments have been presented by way of example only, and are not intended to limit the scope of the inventions. Indeed, the novel devices and methods described herein may be embodied in a variety of other forms; furthermore, various omissions, substitutions and changes in the form of the embodiments described herein may be made without departing from the scope of the inventions. The accompanying claims are intended to cover such forms or modification as would fall within the scope of the inventions.

## Claims

1. A method of manufacturing a semiconductor device (MD), including the steps of:
stacking a first layer (162) mainly composed of silicon and including germanium and oxygen on a first wafer (SS) having a first substrate (150);
forming a first element (MCA) and a first bonding electrode (P_{I1}) in the first wafer;
forming a second element (Tr) and a second bonding electrode (P_{I2}) in a second wafer (SB);
bonding the first wafer and the second wafer via the first bonding electrode and the second bonding electrode; and
transmitting a laser light through the first substrate to irradiate the first layer with the laser light, and thereby induce cleavage the first layer.

2. The method of manufacturing a semiconductor device according to claim 1, wherein
the first substrate is a silicon substrate or a silicon carbide substrate.

3. The method of manufacturing a semiconductor device according to claim 1 or 2, wherein
the first layer is polycrystalline.

4. The method of manufacturing a semiconductor device according to any preceding claim, wherein
the first layer includes germanium dioxide.

5. The method of manufacturing a semiconductor device according to any preceding claim, wherein
an outer peripheral portion (150B) of the first substrate has not undergone trimming processing.

6. The method of manufacturing a semiconductor device according to any preceding claim, wherein
prior to the first layer being stacked on the first wafer, a protective layer (151, 152) is stacked on the first substrate.

7. The method of manufacturing a semiconductor device according to any preceding claim, wherein
prior to the first layer being stacked on the first wafer, a second layer (161A) whose Young's modulus is higher than that of the first layer is stacked on the first wafer, and
after the first layer has been stacked on the first wafer, a third layer (161B) whose Young's modulus is higher than that of the first layer is stacked on the first layer.

8. The method of manufacturing a semiconductor device according to claim 7, wherein
the second layer is a compound including at least one of tungsten, titanium, and silicon.

9. The method of manufacturing a semiconductor device according to any preceding claim, wherein
after the first layer has been stacked on the first wafer, a fourth layer (153) whose reflectance is higher than that of the first layer is stacked on the first wafer.

10. The method of manufacturing a semiconductor device according to claim 9, wherein
the fourth layer includes at least one of tungsten (W), molybdenum (Mo), a titanium-tungsten alloy (TiW), titanium (Ti), and titanium nitride (TiN).

11. The method of manufacturing a semiconductor device according to any preceding claim, wherein
the first element comprises:
a plurality of semiconductor layers (511) stacked in a first direction intersecting the first substrate;
a plurality of third gate electrodes (513) which are stacked in the first direction correspondingly to the plurality of semiconductor layers, and each face surfaces on one side and the other side in the first direction of one of the plurality of semiconductor layers;
a third gate insulating film (512) provided between the plurality of semiconductor layers and the third gate electrode;
a via wiring (504) which extends in the first direction and is electrically connected to the plurality of semiconductor layers; and
a plurality of memory portions (Cap) which are stacked in the first direction correspondingly to the plurality of semiconductor layers, and are connected to side surfaces in a second direction intersecting the first direction, of the plurality of semiconductor layers.

12. The method of manufacturing a semiconductor device according to claim 11, wherein
the plurality of semiconductor layers (511) are each an oxide mainly composed of at least one of titanium and indium.

13. The method of manufacturing a semiconductor device according to claim 11 or 12, wherein
the plurality of memory portions are each a capacitor.

14. The method of manufacturing a semiconductor device according to any preceding claim, wherein
the first element comprises:
a plurality of first gate electrodes (110) stacked in a first direction intersecting the first substrate;
a first semiconductor column (120) extending in the first direction; and
a first gate insulating film (130) provided between the plurality of first gate electrodes and the first semiconductor column.

15. The method of manufacturing a semiconductor device according to claim 14, wherein
the first gate insulating film includes a ferroelectric film (132) mainly composed of at least one of silicon, aluminum, hafnium, and zirconium.

16. The method of manufacturing a semiconductor device according to claim 14 or 15, wherein
the first semiconductor column is an oxide mainly composed of at least one of titanium and indium.

17. The method of manufacturing a semiconductor device according to claim 14, 15 or 16, wherein
the first gate electrode is mainly composed of at least one of polycrystalline silicon, tungsten, molybdenum, and titanium nitride.

18. The method of manufacturing a semiconductor device according to any preceding claim, wherein
a wavelength of the laser light is in a range of 9.2 to 10.8 µm.

19. The method of manufacturing a semiconductor device according to any preceding claim, wherein
after the step of inducing cleavage in the first layer, the second wafer is individualized into a plurality of chips.

20. The method of manufacturing a semiconductor device according to claim 7 or any claim dependent thereon, wherein
a melting point of the second layer is higher than a melting point of the first layer.
